(19) Europäisches Patentamt / European Patent Office / Office européen des brevets

(11) **EP 4 503 255 A1**

(12) **EUROPEAN PATENT APPLICATION**
published in accordance with Art. 153(4) EPC

(43) Date of publication:
05.02.2025 Bulletin 2025/06

(21) Application number: 23780996.7

(22) Date of filing: 30.03.2023

(51) International Patent Classification (IPC):
$H01M\ 10/44^{(2006.01)}$ $\quad$ $G01R\ 31/382^{(2019.01)}$
$G01R\ 31/385^{(2019.01)}$ $\quad$ $G01R\ 31/389^{(2019.01)}$
$H01M\ 10/48^{(2006.01)}$ $\quad$ $H02J\ 7/00^{(2006.01)}$

(52) Cooperative Patent Classification (CPC):
G01R 31/385; G01R 31/36; G01R 31/367;
G01R 31/382; G01R 31/3842; G01R 31/389;
G01R 31/392; H01M 10/425; H01M 10/44;
H01M 10/48; H02J 7/00; H01M 2010/4271;
Y02E 60/10

(86) International application number:
PCT/JP2023/013391

(87) International publication number:
WO 2023/190988 (05.10.2023 Gazette 2023/40)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 30.03.2022 JP 2022057675

(71) Applicant: Vehicle Energy Japan Inc.
Ibaraki 312-8505 (JP)

(72) Inventor: NAKAO, Ryohhei
Tokyo 100-8280 (JP)

(74) Representative: MERH-IP Matias Erny Reichl
Hoffmann
Patentanwälte PartG mbB
Paul-Heyse-Straße 29
80336 München (DE)

(54) **BATTERY CONTROL DEVICE AND BATTERY CONTROL METHOD**

(57) An object is to determine available input/output power of a battery with high accuracy. A battery control device includes: a correction factor calculation unit that determines a correction factor based on a deviation between a state of a secondary battery determined from a measured value related to the secondary battery and a state of the secondary battery calculated using a model related to the secondary battery; and a power limit value calculation unit that employs correction based on the correction factor to calculate a value related to available input/output power of the secondary battery. A ratio between voltage change in internal resistance based on an actual measured voltage obtained by measuring voltage of the secondary battery, and a voltage change in internal resistance based on a model voltage determined using a voltage equivalent circuit model of the secondary battery can be determined as the correction factor.

FIG. 3

**Description**

Technical Field

The present invention relates to a battery control device and a battery control method.

Background Art

Electric vehicle systems installed in electric vehicles such as electric vehicles (EVs), plug-in hybrid electric vehicles (PHEVs), and hybrid electric vehicles (HEVs) are equipped with a battery control device that detects battery voltage, temperature, and current and, based on these data, calculates the battery's state of charge (SOC), state of health (SOH), and the battery's available input/output power (hereafter referred to as "available input/output power") for maximizing performance of the battery.

The available input/output power of a battery is calculated by using the upper or lower limit voltage and the internal resistance of the battery as the maximum power that can be input and output within a range in which the battery voltage does not deviate from the upper and lower limit voltages. Controlling the battery voltage within the range in which it does not deviate from the upper and lower limit voltages makes it possible to avoid use in the high current range in which the battery voltage changes abruptly to suppress battery degradation.

The reason for the abrupt change in battery voltage in the high-current range is that, for example, when a common lithium-ion battery is used as a secondary battery, a concentration gradient of lithium ions occurs in the diffusion layer formed near the interface between the electrode and electrolyte, and a large overvoltage is required to supply lithium ions from the electrolyte to electrode when high current is applied. For this reason, to avoid use of the battery in the high current range, it is desirable for the battery control device to appropriately set the upper limit current value according to the lithium ion concentration gradient in the diffusion layer near the interface between the electrode and electrolyte, which changes in various ways as the battery is charged and discharged.

The technology described in Patent Literature 1 is known with respect to the current limiting method for a secondary battery that takes into account the ionic concentration of the electrolyte.

Citation List

Patent Literature

Patent Literature 1: Japanese Patent Laid-Open No. 2013-137935

Summary of Invention

Technical Problem

In the conventional technology represented by Patent Literature 1, the ion concentration gradient in the diffusion layer formed near the interface between the electrode and the electrolyte is not taken into account, so the upper limit current value cannot be set considering the abrupt change in battery voltage in the high-current range described above.

For example, although during continuous charging or discharging at high current, the internal resistance increases as the lithium ions near the battery electrodes decrease, it is difficult to accurately model such behavior. When a battery is charged and discharged in a range that cannot be reproduced by the voltage equivalent circuit model, calculation errors occur in the internal resistance of the battery, and as a result, the available input/output power cannot be accurately calculated; thus, the battery voltage would deviate from the upper and lower limit voltages even though the battery is charged and discharged according to the available input/output power.

An object of the present invention is to improve the calculation accuracy of the battery's available input/output power.

Solution to Problem

To solve the aforementioned problem, the present invention includes: a correction factor calculation unit that determines a correction factor based on a deviation between a state of a secondary battery determined from a measured value related to the secondary battery and a state of the secondary battery calculated using a model related to the secondary battery; and a power limit value calculation unit that employs correction based on the correction factor to calculate a value related to available input/output power of the secondary battery.

Advantageous Effect of Invention

According to the present invention, the battery's available input/output power can be determined with high accuracy.

Brief Description of Drawings

[Figure 1] Figure 1 is a block diagram showing the configuration of an electric system of a hybrid vehicle which is a first embodiment of the present invention.
[Figure 2] Figure 2 is a block diagram showing the configuration of a single battery control unit that constitutes the battery system shown in Figure 1.
[Figure 3] Figure 3 is a block diagram showing the configuration of an assembled battery control unit that constitutes the battery system shown in Figure 1.
[Figure 4] Figure 4 is a table for explaining a data table showing the relationship between SOC and OCV.
[Figure 5] Figure 5 is a block diagram showing the configuration of the SOC calculation unit that constitutes the assembled battery control unit in Embodiment 1.
[Figure 6] Figure 6 is a diagram for explaining how to calculate SOC from OCV.
[Figure 7] Figure 7 is a block diagram showing the configuration of an SOH calculation unit that constitutes the assembled battery control unit in Embodiment 1.
[Figure 8] Figure 8 is a block diagram showing the configuration of a power limit value calculation unit that constitutes the assembled battery control unit of Embodiment 1.
[Figure 9] Figure 9 is a diagram showing an example of an equivalent circuit model of a battery.
[Figure 10] Figure 10 is a diagram showing battery voltage behavior.
[Figure 11] Figure 11 shows voltage behavior observed when internal resistance increases due to lithium ion diffusion.
[Figure 12] Figure 12 is a block diagram showing the configuration of the power limit value calculation unit of Embodiment 1 of the present invention.
[Figure 13] Figure 13 shows power, current, and voltage waveforms observed when power equivalent to the available output power is input to the battery before Embodiment 1 of the present invention is applied.
[Figure 14] Figure 14 shows power, current, and voltage waveforms when observed power equivalent to the available output power is input to the battery when Embodiment 1 of the present invention is applied.
[Figure 15] Figure 15 is a block diagram showing the configuration of an assembled battery control unit constituting the battery system of Embodiment 2 shown in Figure 1.
[Figure 16] Figure 16 is a block diagram showing the configuration of a power limit value calculation unit of Embodiment 2 of the present invention.
[Figure 17] Figure 17 is a schematic view of an assembled battery consisting of single batteries with different internal resistance values connected in series.
[Figure 18] Figure 18 shows power, current, and voltage waveforms observed when power equivalent to the available output power is input to the battery before Embodiment 2 of the present invention is applied.
[Figure 19] Figure 19 shows power, current, and voltage waveforms observed when power equivalent to the available input power is input to the battery before Embodiment 2 of the present invention is applied.
[Figure 20] Figure 20 shows power, current, and voltage waveforms observed when power equivalent to the available output power is input to the battery when Embodiment 2 of the present invention is applied.
[Figure 21] Figure 21 shows power, current, and voltage waveforms observed when power equivalent to the available input power is input to the battery when Embodiment 2 of the present invention is applied.
[Figure 22] Figure 22 is a block diagram showing the configuration of a power limit value calculation unit of Embodiment 3 of the present invention.
[Figure 23] Figure 23 is a diagram showing a power limiting factor of Embodiment 3 of the present invention.
[Figure 24] Figure 24 shows power, current, and voltage waveforms observed when power equivalent to the available output power is input to the battery when Embodiment 3 of the present invention is applied.
[Figure 25] Figure 25 shows power, current, and voltage waveforms observed when power equivalent to the available input power is input to the battery when Embodiment 3 of the present invention is applied.
[Figure 26] Figure 26 is a block diagram showing the configuration of the assembled battery control unit constituting a battery system of Embodiment 4 shown in Figure 1.
[Figure 27] Figure 27 is a block diagram showing the configuration of the SOH calculation unit that constitutes an assembled battery control unit of Embodiment 4.
[Figure 28] Figure 28 is a block diagram showing the configuration of the power limit value calculation unit of Embodiment 4 of the present invention.

[Figure 29] Figure 29 is a diagram showing the waveforms of current, voltage, SOH, correction factor kchg, and maximum available output power Pmax_d during pulse current input before application of Embodiment 4 of the present invention.

[Figure 30] Figure 30 is a diagram showing the waveforms of current, voltage, SOH, correction factor kchg, and maximum available output power Pmax_d during pulse current input after application of Embodiment 4 of the present invention.

Description of Embodiments

Embodiments of the present invention will be described with reference to the accompanying drawings.

In the embodiments described below, application to an energy accumulating apparatus that constitutes the power source of a hybrid electric vehicle (HEV) will be explained as an example.

The configuration of the embodiment described below can also be applied to the energy accumulator control circuit of an energy accumulating apparatus that constitutes the power source for passenger cars such as plug-in hybrid electric vehicles (PHEVs) and electric vehicles (EVs) and industrial vehicles such as hybrid railcars.

In the embodiments described below, application of a lithium-ion battery as an energy accumulator that constitutes the energy accumulating unit will be explained as an example. Other energy accumulators such as nickel-metal hydride batteries, lead-acid batteries, electric double layer capacitors, and hybrid capacitors can also be used.

Embodiment 1

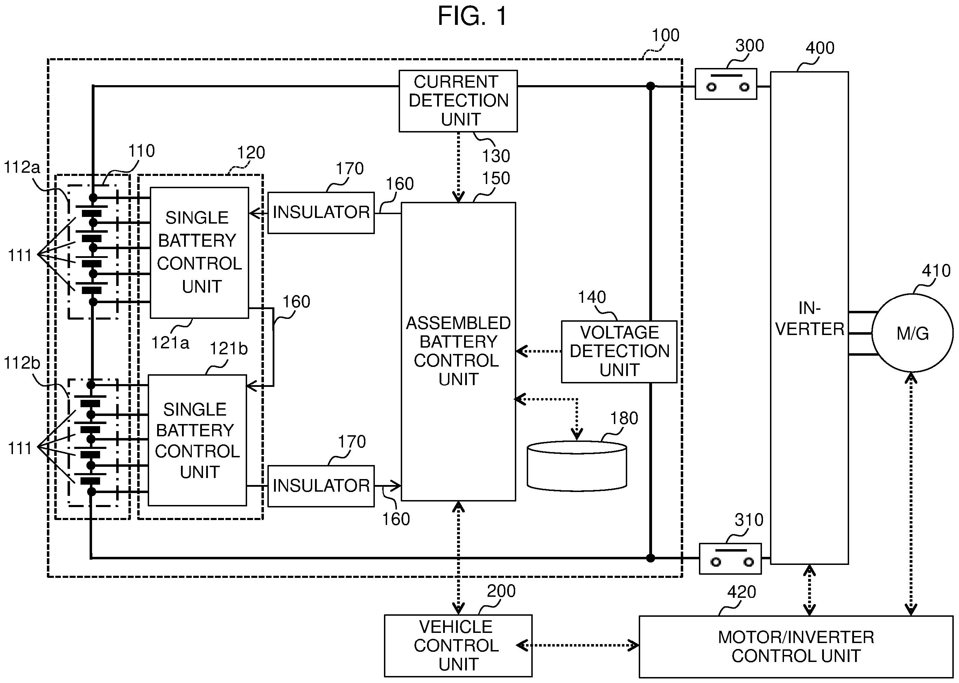

The first embodiment of the present invention will be described with reference to Figures 1 to 14.

Figure 1 shows an example of the configuration of the electric system of a hybrid vehicle of this embodiment. The electric system of this embodiment has a battery 100, an inverter 400 coupled to the battery 100 via relays 300 and 310, and a motor 410. A vehicle control unit 200 determines the distribution of driving force and the like based on the SOC of the battery 100 and other information from the inverter 400 or motor 410, and information from the engine (not shown in the drawings).

The configuration of the battery 100 will be described below. The battery 100 has an assembled battery 110, a single battery management unit 120, a current detection unit 130, a voltage detection unit 140, an assembled battery control unit 150, and a memory unit 180. The assembled battery 110 is composed of multiple single batteries 111. The single battery management unit 120 monitors the status of the single batteries 111. The current detection unit 130 detects the current flowing in the battery 100. The voltage detection unit 140 detects the total voltage of the assembled battery 110. The assembled battery control unit 150 controls the assembled battery 110. The memory unit 180 stores information about the battery characteristics of the assembled battery 110, the single batteries 111, and a single battery group 112. The assembled battery control unit 150 receives the battery voltage and temperature of the single batteries 111, the value of the current flowing in the battery, the value of the total voltage of the assembled battery 110, the diagnostic results of the single batteries 111, and an error signal. The battery voltage and temperature of the single batteries 111 are transmitted from the single battery management unit 120. The value of the current flowing in the battery is transmitted from the current detection unit 130. The value of the total voltage of the assembled battery 110 is transmitted from the voltage detection unit 140. The diagnostic result of the single batteries 111 indicates whether it is overcharged or overdischarged. Error signals are output when a communication error occurs in the single battery management unit 120. The assembled battery control unit 150 performs, for example, detection of the status of the assembled battery 110 based on the input information. The results of the processes performed by the assembled battery control unit 150 are transmitted to the single battery management unit 120 and the vehicle control unit 200.

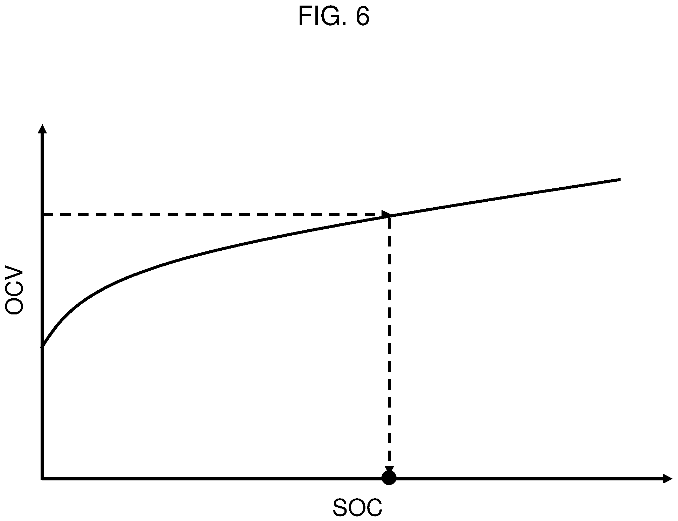

The assembled battery 110 consists of multiple single batteries 111 (lithium-ion batteries) electrically connected in series, which can store and release electric energy (charge and discharge of DC power). Although the case where each single battery 111 has an output voltage of 3.0 to 4.2 V (average output voltage: 3.6 V) and the OCV and SOC of the single battery 111 have the correlation shown in Figure 6 is taken as an example, other voltage specifications are also acceptable.

The single batteries 111 constituting the assembled battery 110 are grouped into a predetermined number of units for status management and control. The grouped single batteries 111 are electrically connected in series to form a single battery group 112. The predetermined number of units may be classified equally, for example, one, four, six, ..., or it may be a composite classification, for example, a combination of four and six.

The single battery management unit 120, which monitors the status of the single batteries 111 constituting the assembled battery 110, is composed of multiple single battery control units 121, and one single battery control unit 121 is allocated to each single battery group 112 that is grouped as described above. The single battery control unit 121 operates by receiving power from the allocated single battery group 112 and monitors the battery voltage and temperature of the single batteries 111 that constitute the single battery group 112. In Figure 1, single battery control units 121a and 121b are provided for single battery groups 112a and 112b, respectively. In this embodiment, for simplicity of explanation, it is assumed that the single battery groups 112 consist of four single batteries 111 electrically connected in series, and the four single batteries 111 are monitored by one single battery control unit 121.

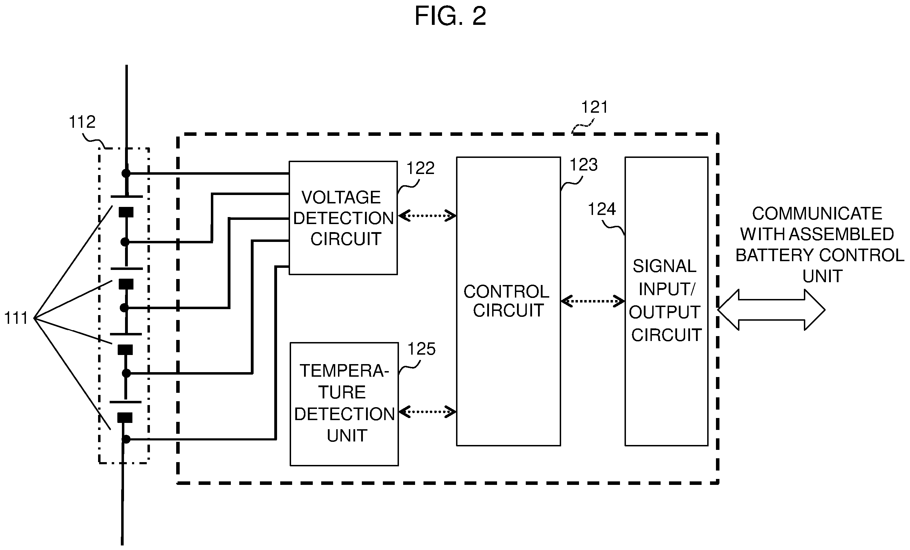

Figure 2 shows the circuit configuration of the single battery control unit 121. The single battery control unit 121 has a voltage detection circuit 122, a control circuit 123, a signal input/output circuit 124, and a temperature detection unit 125. The voltage detection circuit 122 measures the voltage between the terminals of each single battery 111. The temperature detection unit 125 measures the temperature of the single battery group 112. The control circuit 123 receives the measurement results from the voltage detection circuit 122 and the temperature detection unit 125 and transmits them to the assembled battery control unit 150 via the signal input/output circuit 124. Any existing technology can be used for the circuit configuration that is commonly implemented in the single battery control unit 121 to equalize the voltage and SOC variations among the single batteries 111 that occur due to variations in self-discharge, current consumption, and the like.

The temperature detection unit 125 included in the single battery control unit 121 in Figure 2 has the function of measuring the temperature of the single battery group 112. The temperature detection unit 125 measures one temperature for the single battery group 112 as a whole and treats that temperature as representative of the temperatures of the single batteries 111 constituting the single battery group 112. The temperature measured by the temperature detection unit 125 is used for various calculations to detect the state of the single batteries 111, the single battery group 112, or the assembled battery 110. Figure 2 assumes this, so one temperature detection unit 125 is provided in the single battery control unit 121. It is also possible to install a temperature detection unit 125 for each single battery 111, measure the temperature of each single battery 111, and perform various calculations based on the temperature of each single battery 111, but in this case, the configuration of the single battery control unit 121 becomes more complex because the number of temperature detection units 125 increases.

Figure 2 simply shows the temperature detection unit 125. In reality, a temperature sensor is installed on the temperature measurement target, the installed temperature sensor outputs temperature information as voltage, the result of this measurement is transmitted to the signal input/output circuit 124 via the control circuit 123, and the signal input/output circuit 124 outputs the measurement result to the outside of the single battery control unit 121. The function for realizing this series of flow is implemented in the single battery control unit 121 as the temperature detection unit 125, and the voltage detection circuit 122 can also be used to measure the temperature information (voltage).

The assembled battery control unit 150 and the single battery management unit 120 transmit and receive signals using a signal communication unit 160 through an insulator 170, such as a photocoupler. The reason for providing the insulator 170 is that the assembled battery control unit 150 and the single battery management unit 120 use different operating power sources. In other words, the single battery management unit 120 operates on power from the assembled battery 110, while the assembled battery control unit 150 uses a battery for in-vehicle auxiliary equipment (e.g., a 12 V battery) as its power source. The insulator 170 can be mounted on a circuit board that constitutes the single battery management unit 120 or on a circuit board that constitutes the assembled battery control unit 150. Depending on the system configuration, the aforementioned insulator 170 can be omitted.

The communication unit between the assembled battery control unit 150 and the single battery control units 121a and 121b in this embodiment will be described below. The single battery control units 121a and 121b are connected in series in descending order of potential of the single battery groups 112a and 112b that they monitor respectively. Signals transmitted by the assembled battery control unit 150 are input to the single battery control unit 121a by the signal communication unit 160 through the insulator 170. Similarly, the output of single battery control unit 121a and the input of the single battery control unit 121b are connected using the signal communication unit 160 for signal transmission. In this embodiment, the single battery control units 121a and 121b are not connected via an insulator 170, but may be connected via an insulator 170. The output of the single battery control unit 121b is transmitted by the signal communication unit 160 through the insulator 170 and through the input of the assembled battery control unit 150. Thus, the assembled battery control unit 150 and the single battery control units 121a and 121b are connected in a loop through the signal communication unit 160. This loop connection may be referred to as a daisy-chain connection, a bead-to-bead connection, or a potato-spinning connection.

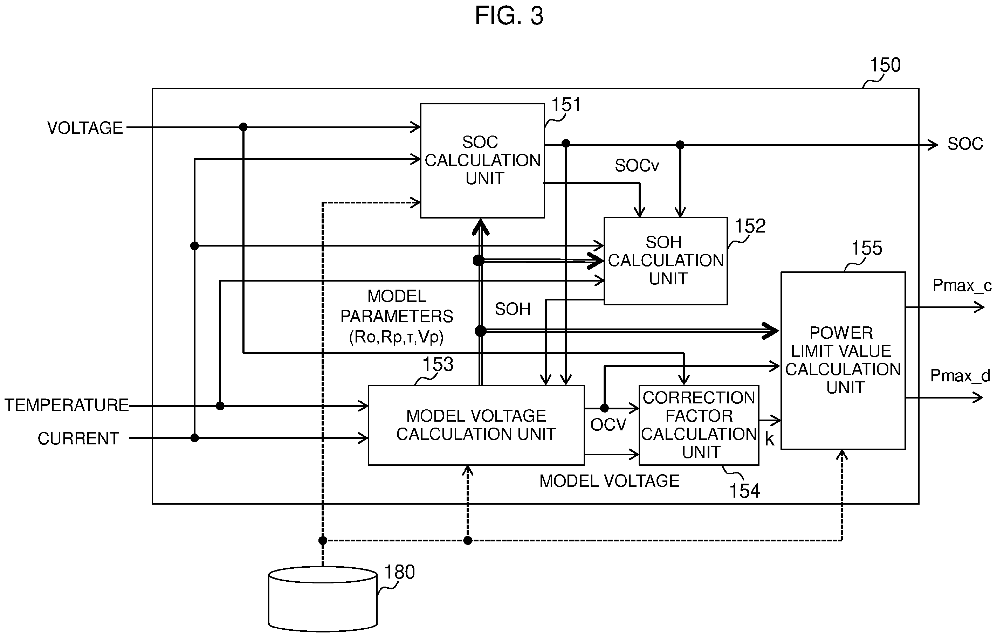

The configuration of the assembled battery control unit 150 will be described with reference to Figure 3. This embodiment omits, for simplicity, the description of the processing details based on the diagnostic results related to the single batteries 111 and the error signals output when a communication error or the like occurs in the single battery management unit 120. The assembled battery control unit 150 consists of an SOC calculation unit 151, SOH calculation unit 152, model voltage calculation unit 153, correction factor calculation unit 154, and power limit value calculation unit 155.

The SOC calculation unit 151 outputs SOC and SOCv using as inputs the average voltage of each of the single batteries 111 constituting the assembled battery 110, the current flowing in the assembled battery 110, and the model parameters output from the model voltage calculation unit 153 (described below). The details of the calculation process for SOC and SOCv are will be explained below. The SOH calculation unit 152 uses as inputs the SOC and SOCv output from the SOC calculation unit 151 and the model parameters output from the model voltage calculation unit 153 to calculate and output SOH which indicates the battery degradation rate. The model voltage calculation unit 153 outputs various model parameters and the voltage of the battery using the current, temperature, SOC, and SOH as inputs. SOC is obtained as a result of calculation performed in the SOC calculation unit 151. SOH is obtained as a result of calculation performed in the SOH calculation unit 152. The various model parameters are parameters that constitute the voltage equivalent circuit model that predicts the battery's voltage. The voltage output from the model voltage calculation unit 153 includes the model voltage and OCV. The correction factor calculation unit 154 performs the correction factor calculation step. The correction factor calculation step is a step in which the correction factor k is calculated and output using the measured battery voltage and the model voltage and OCV calculated by the model voltage calculation unit 153 as inputs. The power limit value calculation unit 155 performs a power limit value calculation step. The power limit value calculation step is a step in which the maximum available input power (Pmax_c) and the maximum available output power (Pmax_d) are output using as inputs the model parameters (Ro, Rp, $\tau$, and Vp described below) calculated by the model voltage calculation unit 153, OCV, and correction factor k.

The memory unit 180 stores information such as internal resistance characteristics, capacity at full charge, polarization resistance characteristics, degradation characteristics, individual difference information, and correspondence relationship between SOC and OCV of the assembled battery 110, single batteries 111, and single battery group 112. Although in this embodiment the memory unit 180 is configured to be located outside the assembled battery control unit 150 or single battery management unit 120, the assembled battery control unit 150 or single battery management unit 120 may be configured to include a memory unit and store the aforementioned information.

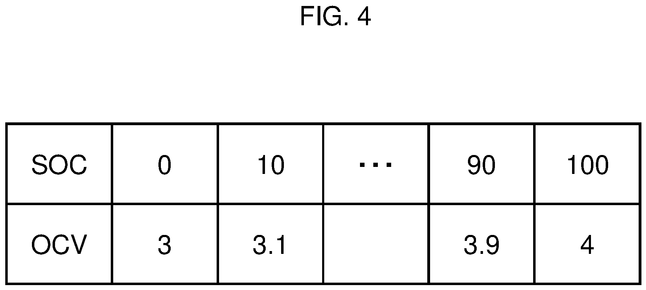

Figure 4 shows an example of SOC table stored in the memory unit 180. The SOC table is a data table in which the correspondence relationship between the OCV of the single batteries 111 and the SOC of the single batteries 111 are described according to the temperature. The memory unit 180 also stores other various battery characteristic information, such as internal resistance characteristics and polarization resistance characteristics, as a data table describing the correspondence relationship with various parameters such as SOC and temperature, similarly to the SOC table. Although a data table is used in the description of this embodiment, the correspondence relationship between OCV and SOC may be expressed by a mathematical formula or the like, and is not limited to the form of a data table.

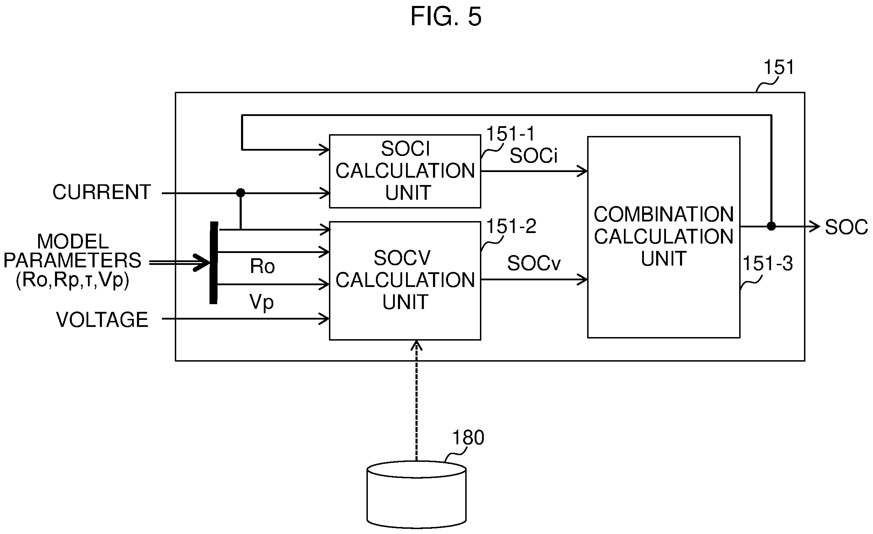

The SOC calculation unit 151, which constitutes the assembled battery control unit 150, will be described with reference to Figures 5 and 6. The SOC calculation unit 151 is composed of an SOCi calculation unit 151-1, SOCv calculation unit 151-2, and combination calculation unit 151-3. The SOCi calculation unit 151-1 uses the current and the previous value of the SOC calculation result output from the combination calculation unit 151-3 (the calculation result from one cycle ago) as inputs to calculate and output the SOC based on the integrated value of current (hereafter referred to as SOCi). The SOCv calculation unit calculates the OCV based on the battery voltage, current, and temperature, and SOC (hereafter referred to as SOCv) based on the correspondence relationship between OCV and SOC shown in Figure 6. The combination calculation unit 151-3 uses SOCi and SOCv as inputs and outputs a weighted average of SOCi and SOCv.

The SOCi calculation unit 151-1 will be described below. SOCi is calculated by adding the amount of change in SOC due to the current flow to the previous value of the result output from the combination calculation unit 151-3 (calculation result from one cycle ago).(Equations (1))

[Formula 1]

$$\left. \begin{aligned} SOCi &= SOC\_old + \Delta SOC \\ \Delta SOC &= 100 \times I \times ts / Q\max \end{aligned} \right\} \quad \cdots \quad (1)$$

Here, SOC_old is the previous value of SOC (the result of calculation of one cycle ago) obtained by Equation (4) described below, I is the current, Qmax is the fully charged capacity of the single battery 111, and ts is the control cycle (sampling cycle for current, voltage, and the like).

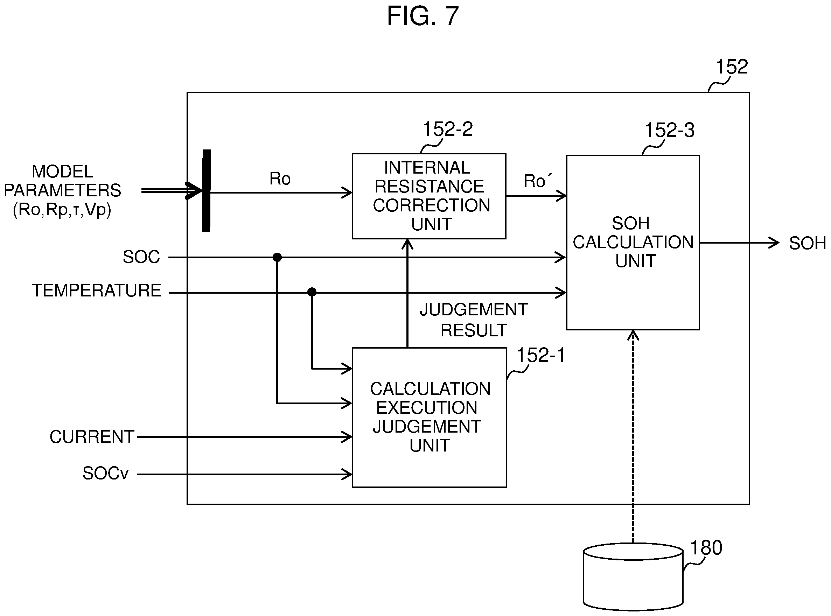

The SOCv calculation unit 151-2 will be described below. The SOCv calculation unit 151-2 calculates the battery's OCV using as inputs the voltage, current, and model parameters of the battery (Ro and Vp, which will be described below. Among the model parameters in Figure 5, only Ro and Vp used for SOC calculation are extracted and utilized as inputs) and estimates SOCv from the correspondence relationship between SOC and OCV shown in Figure 6. OCV is calculated based on the voltage equivalent circuit shown in Figure 7 (the details will be described below). According to the equivalent circuit in Figure 7, the OCV of the battery can be expressed by the following equations (2).

[Formula 2]

$$\left. \begin{aligned} OCV &= CCV - (Vo + Vp) \\ Vo &= I \times Ro \\ SOCv &= Map(OCV) \end{aligned} \right\} \quad \cdots \quad (2)$$

The combination calculation unit 151-3 will be described below. The combination calculation unit 151-3 calculates SOC based on the following equation (3), using SOCi calculated by the SOCi calculation unit 151-1, SOCv calculated by the SOCv calculation unit 151-2, current, and temperature as inputs.
[Formula 3]

$$SOC = w \times SOCv + (1 - w) \times SOCi \quad \ldots \quad (3)$$

Here, w indicates the weighting factor, which is calculated, for example, using the following equation (4).
[Formula 4]

$$w = 1 / (1 + |I| \times R) \quad \ldots \quad (4)$$

Equation (4) shows that when the current is large, w is small, resulting in a higher degree of bias toward SOCi, and conversely, when the current is small, w is large, resulting in a higher degree of bias toward SOCv. In this embodiment, the weighting factor like that in Equation (4) is provided to avoid the influence of SOCv error caused by resistance error that occurs upon energization; however, this is not necessarily the case.

Next, the SOH calculation unit 152 will be described with reference to Figure 7. The SOH calculation in this embodiment is a method of extracting and correcting the difference between the SOC as input and the SOCv calculated using the internal resistance Ro, as an error in Ro (change in Ro due to degradation).

The SOH calculation unit 152 has a calculation execution judgement unit 152-1, an internal resistance correction unit 152-2, and a SOH calculation unit 152-3. The calculation execution judgement unit 152-1 judges whether or not to execute SOH calculation based on SOC and SOCv, current, and temperature. The internal resistance correction unit 152-2 corrects Ro, one of the model parameters (extracts and utilizes among the model parameters, only Ro used for SOH calculation) based on the judgement result obtained in the calculation execution judgement unit 152-1. The SOH calculation unit 152-3 uses SOC, temperature, and corrected Ro (Ro') as inputs and calculates the ratio to the initial Ro. The details of these processing units will be described below.

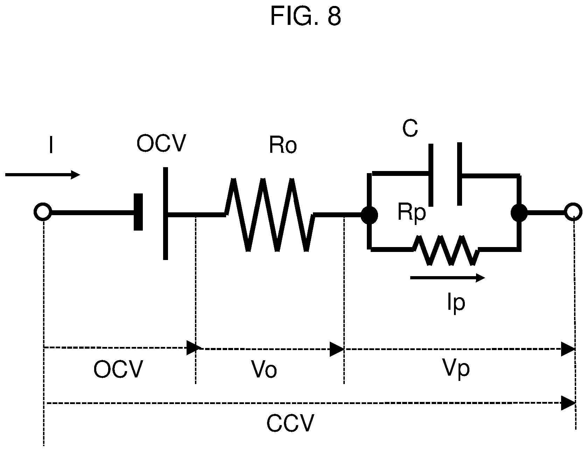

The calculation execution judgement unit 152-1 judges whether or not to execute the internal resistance correction calculation, using SOC, SOCv, current, and temperature as inputs. To be specific, it checks whether the SOC, current, temperature, and energization time are within a predetermined range, and if all conditions are met, the calculation is enabled and the judgement result is output. The ranges of SOC, current, temperature, and energization time are determined taking into account the battery characteristics, whether the voltage behavior can be predicted with the battery equivalent circuit model shown in Figure 8 described below (whether charging or discharging is occurring in an area that cannot be reproduced by the equivalent circuit model), SOC error, and the influence of current and temperature sensor error. If the calculation execution judgement unit 152-1 determines that calculation is possible, it compares SOC and SOCv to determine whether or not Ro correction is necessary and the direction of the correction.

The internal resistance correction unit 152-2 corrects Ro, which is the input, when the correction is judged to be necessary by the calculation execution judgement unit 152-1. To be specific, if the correction is judged to be necessary and the resistance value needs to be corrected to a lower value, a predetermined value is subtracted from Ro. Conversely, if the resistance value needs to be corrected to a higher value, a predetermined value is added to Ro.

The SOH calculation unit 152-3 calculates the initial Ro (internal resistance value RoInit obtained when it is new) dependent on Ro' calculated by the internal resistance correction unit 152-2 and the SOC and temperature serving as inputs, which is then determined as the rate of increase of Ro based on the following Equation (5).
[Formula 5]

$$SOH = 100 \times Ro' / RoInit \quad \ldots \quad (5)$$

If the execution of the internal resistance calculation is judged to be infeasible based on the judgement result given by the calculation execution judgement unit 152-1, the internal resistance value is not corrected, i.e., the internal resistance value from one calculation cycle ago is output. For example, when calculation processing is performed in an arbitrary calculation cycle, the internal resistance from one calculation cycle prior to the calculation cycle in which the execution is determined to be infeasible is output.

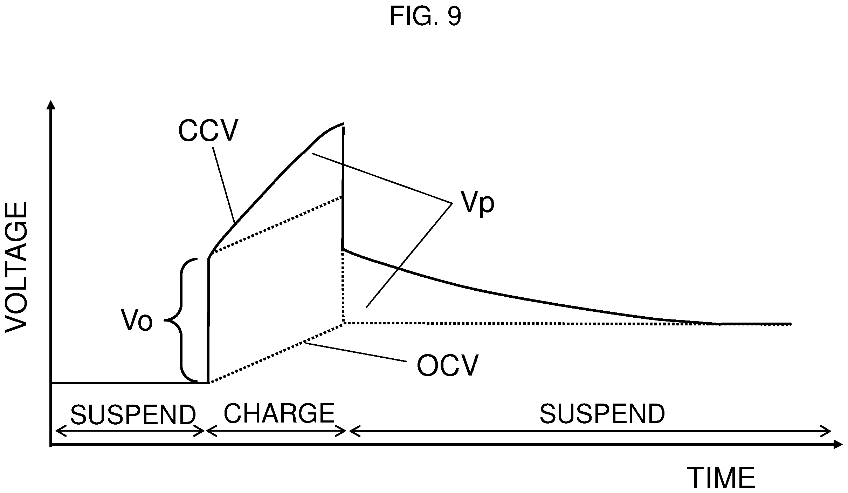

The model voltage calculation unit 153, which constitutes the assembled battery control unit 150, will now be described with reference to Figures 8 and 9.

Figure 8 shows a voltage equivalent circuit model that reproduces the battery voltage. In the equivalent circuit model shown in the figure, an internal resistance Ro and a parallel circuit of Rp and C are connected in series with the electromotive force component which indicates the open circuit voltage (OCV) of the battery. The internal resistance Ro is a resistance component caused by the electrodes, electrolytic solution, and other components of the battery and is independent of time. The parallel circuit of Rp and C simulates the internal resistance component caused by the electrochemical reaction of the battery. Hereafter, Rp will be referred to as the polarization resistance and the time constant $\tau$ (= Rp x C) in the parallel circuit will be referred to as the polarization time constant. In this equivalent circuit model, the battery voltage, CCV, is calculated by the following equations (6). Vp_z in the equations (6) represents the polarization voltage from one calculation cycle ago.

[Formula 6]

$$\left.\begin{array}{l} \mathrm{CCV} = \mathrm{OCV} + \mathrm{Vo} + \mathrm{Vp} \\ \mathrm{Vo} = \mathrm{I} \times \mathrm{Ro} \end{array}\right\} \quad \cdots \quad (6)$$

$$\mathrm{Vp} = \left(\frac{ts}{\tau}\right) \times I \times Rp + \left(1 - \left(\frac{ts}{\tau}\right)\right) \times Vp\_z$$

The model parameters in the equivalent circuit model, OCV, Ro, Rp, and $\tau$, can be extracted from the voltage waveforms obtained when the battery is charged or discharged. Figure 9 shows the voltage waveforms obtained when a constant charging current is input to the battery. As shown in Figure 9, at the moment the charging current is input, a voltage change (Vo) by the Ro, which is a time-independent internal resistance component, is generated with respect to OCV, and a polarization voltage Vp, which is a voltage component that changes over time with a time constant $\tau$, is then generated. After the end of charging, the voltage change by the Vo becomes zero, the polarization voltage Vp gradually relaxes with the time constant $\tau$, and eventually the battery voltage approaches OCV. After such experiments are conducted at each SOC, temperature, charge and discharge, and the voltage before the start of charge and discharge is extracted as OCV, Ro, Rp, and $\tau$ are extracted applying, for example, the least-squares method to reproduce the voltage change under each condition, and a database is constructed and stored as a map in the memory unit 180.

In the model voltage calculation unit 153 in this embodiment, the OCV for each SOC and temperature extracted in advance, the Ro map (RoInitMap) obtained when it was new, the Rp map (RpInitMap) obtained when it was new, and the $\tau$ map ($\tau$Map) are implemented in the memory unit 180, and using SOC, SOH and temperature as inputs, the model parameters such as Ro, Rp, $\tau$, and Vp corresponding to SOC, SOH, and temperature, and the model voltage CCV are calculated and output. The model parameters are calculated by the following equations (7), respectively. The model voltage CCV is calculated by the equations (6) above.

[Formula 7]

$$\left.\begin{array}{l} \mathrm{OCV} = \mathrm{OCVMap}(\mathrm{SOC}, \mathrm{T}) \\ \mathrm{Ro} = \mathrm{RoInitMap}(\mathrm{SOC}, \mathrm{T}) \times \mathrm{SOH}/100 \\ \mathrm{Rp} = \mathrm{RpInitMap}(\mathrm{SOC}, \mathrm{T}) \times \mathrm{SOH}/100 \\ \tau = \tau\mathrm{Map}(\mathrm{SOC}, \mathrm{T}) \end{array}\right\} \quad \cdots \quad (7)$$

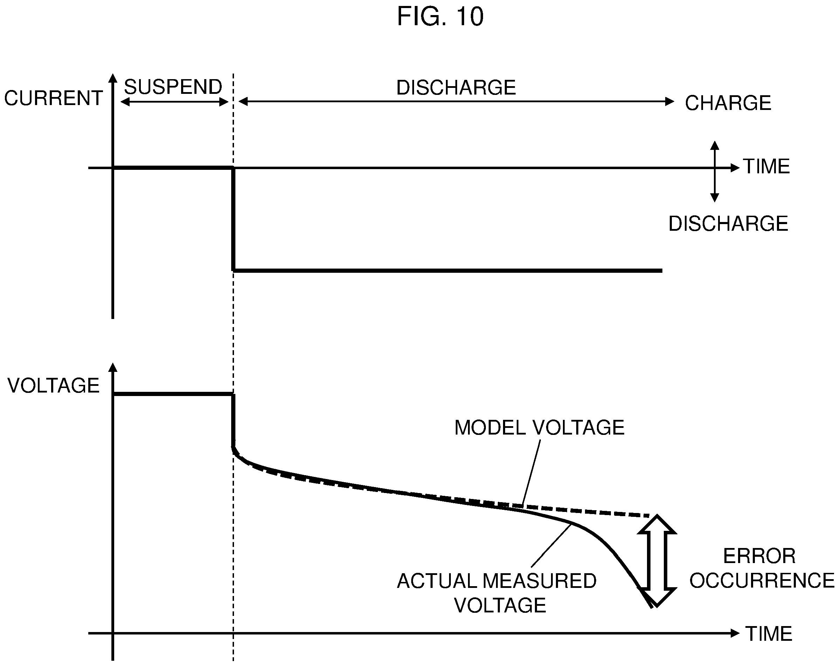

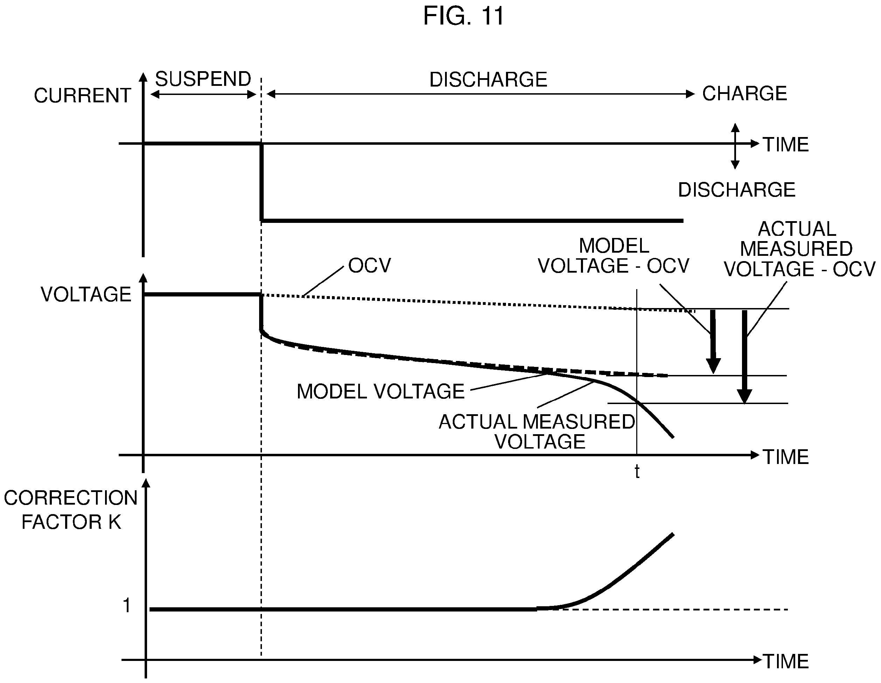

Next, the correction factor calculation unit 154 in this embodiment will be described based on Figures 10 and 11. Figure 10 shows the voltage waveform obtained when a certain square wave current is input to the battery as in Figure 9, and is the waveform obtained when it is continuously energized with a large current for a long period of time. The solid line shows the waveform of the battery voltage of the actual battery, and the dotted line shows the voltage waveform calculated by the equivalent circuit model that is described with reference to Figure 8. It can be seen that in the region where the energization time is short, the solid and dotted lines coincide well, but the discrepancy widens with time, and in the latter half of the discharge, the behavior of the actual battery represented by the solid line bends largely, showing that the deviation of the behavior from the model voltage is very different. The phenomenon that the voltage behavior bends largely during long-time energization is caused when the internal resistance component that contributes to the diffusion of lithium ion inside the battery becomes larger as the lithium ion at the electrode-electrolyte interface decreases. As this behavior is not reproduced by the equivalent circuit model shown in Figure 8, a large deviation probably occurred in the voltage behavior in the latter half of discharge.

If the battery is charged and discharged with large deviations in voltage (resistance) behavior, the available input/output power, which will be described below, cannot be accurately calculated, which may cause deviation from the upper and lower limit voltages that must be met. There is a means to solve this problem to construct a voltage equivalent circuit model that can be reproduced including the region where the voltage bends as shown in Figure 10; however, in general, modeling that region is very difficult. For this reason, in order to calculate the available input/output power more accurately even in charging/discharging in regions that cannot be reproduced by the voltage model, this embodiment explains a method in which correction factors are calculated based on the actual measured voltage and model voltage, and reflected in the available input/output power calculation.

Figure 11 shows an example of the method of calculating the correction factor in this embodiment. In this embodiment, the voltage change due to internal resistance is calculated from the model voltage and the actual measured voltage, and the ratio between these is extracted as a correction factor (Equation (8)).

[Formula 8]

$$k = \frac{CCVmeas - OCV}{CCVCalc - OCV} \quad \cdots \quad (8)$$

In Equation (8), CCVmeas represents the actual measured voltage and CCVCalc represents the model voltage. The difference between OCV and CCV represents the voltage change due to internal resistance, and the ratio of the voltage change obtained from the actual measured voltage (actual measured voltage - OCV in Figure 11) to the voltage change obtained from the model voltage (model voltage - OCV) shows how many times the actual internal resistance of the battery is compared to the internal resistance calculated with the voltage model. The result of this calculation is the correction factor k shown in Figure 11. The correction factor calculation unit 154 calculates the correction factor k according to Equation (8) and outputs it to the power limit value calculation unit 155 described below.

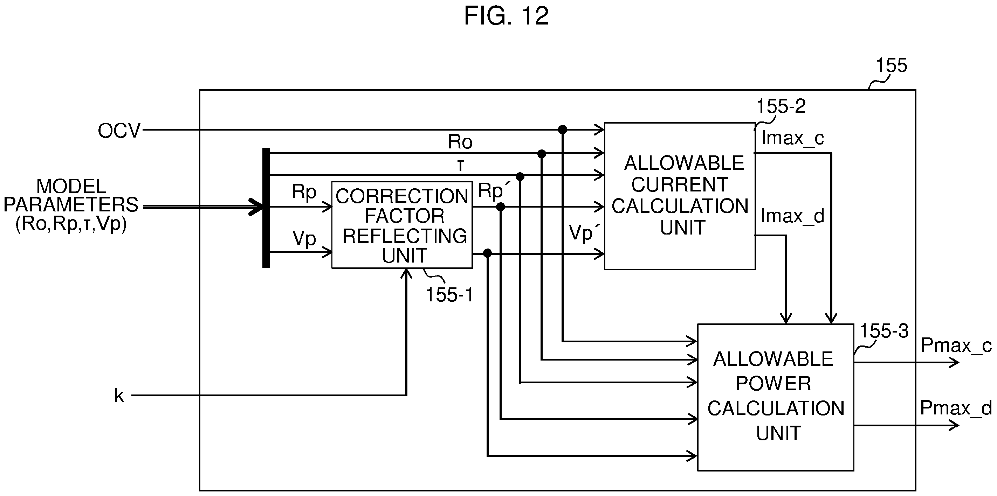

The power limit value calculation unit 155 will be described with reference to Figure 12. The power limit value calculation unit 155 inputs, among the model parameters, the time-dependent polarization resistance Rp and polarization voltage Vp, and the correction factor k obtained by the correction factor calculation unit 154. The power limit value calculation unit 155 has a correction factor reflecting unit 155-1, an allowable current calculation unit 155-2, and an allowable power calculation unit 155-3. The correction factor reflecting unit 155-1 corrects Rp and Vp. The allowable current calculation unit 155-2 calculates the maximum available input current Imax_c and the maximum available output current Imax_d of the battery, using the OCV and the model parameters including the parameters corrected by the correction factor reflecting unit 155-1 as inputs. The allowable power calculation unit 155-3 calculates and outputs the maximum available input power Pmax_c and the maximum available output power Pmax_d, using the OCV, the model parameters including the parameters corrected by the correction factor reflecting unit 155-1, Imax_c, and Imax_d as inputs.

The correction factor reflecting unit 155-1 corrects the model parameters used in the calculation of Imax_c, Imax_d, Pmax_c, and Pmax_d, using the correction factor k as an input. Since the correction factor k is a factor that reflects the effect of the polarization component that changes with time, Ro, which is a resistance component that is not time-dependent in the first place, is excluded from the correction target, and only the polarization resistance Rp and polarization voltage Vp are utilized for correction. In this embodiment, the following equation (9) is used to correct the polarization resistance Rp and polarization voltage Vp.

[Formula 9]

$$\left. \begin{array}{l} Rp\acute{} = k \times Rp \\ \\ Vp\acute{} = k \times Vp \end{array} \right\} \quad \cdots \quad (9)$$

The allowable current calculation unit 155-2 calculates the maximum available input current Imax_c and maximum available output current Imax_d of the battery according to the following equations (10) and (11), using the model parameters including Rp and Vp corrected in Equation (9) and OCV as inputs.

[Formula 10]

$$\left. \begin{array}{l} I_{chg} = \dfrac{Vmax - \left(OCV(SOC, T) + Vp' \times \exp\left(-\dfrac{tcont}{\tau}\right)\right)}{Ro + Rp\acute{} \times \left(1 - \exp\left(-\dfrac{tcont}{\tau}\right)\right)} \\ \\ I_{\max\_c} = \min\left(I_{chg}, Ilimit\right) \end{array} \right\} \quad \cdots \quad (10)$$

[Formula 11]

$$I_{\text{dis}} = \frac{\left(OCV(SOC, T) + Vp' \times \exp\left(-\frac{tcont}{\tau}\right)\right) - Vmin}{Ro + Rp' \times (1 - \exp\left(-\frac{tcont}{\tau}\right))} \left.\vphantom{\frac{1}{1}}\right\} \quad \cdots \ (11)$$

$$I_{\text{max}\_d} = \min(I_{dis}, Ilimit)$$

Here, tcont in Equations (10) and (11) represents the assumed continuous energizing seconds (sec), Ilimit represents the upper limit current value determined in consideration of the resistance of relays and fuses, which are components of the battery system, Vmax and Vmin represent the upper and lower limit voltages, respectively. The assumed continuous energizing seconds is the number of seconds to be set when the current and power that can be continuously supplied for a predetermined number of seconds are specified. For example, when the current or power that can be continuously supplied for 5 seconds is calculated, 5 is set as tcont.

Next, the allowable power calculation unit 155-3 uses the model parameters including Rp and Vp corrected using Equation (9), OCV, and Imax_c and Imax_d calculated by the allowable current calculation unit 155-2 as inputs to calculate the maximum available input power Pmax_c and maximum available output power Pmax_d according to Equations (12) and (13) below.

[Formula 12]

$$P_{\text{max}\_c} = N \times I_{\text{max}\_c} \times \left(OCV + I_{\text{max}\_c} \times (R_0 + Rp' \times (1 - \exp\left(-\frac{tcont}{\tau}\right))) + Vp' \times \exp\left(-\frac{tcont}{\tau}\right)\right)$$

$$\cdots \ (12)$$

[Formula 13]

$$P_{\text{max}\_d} = N \times I_{\text{max}\_d} \times \left(OCV - I_{\text{max}\_d} \times (R_0 + Rp' \times (1 - \exp\left(-\frac{tcont}{\tau}\right))) + Vp' \times \exp\left(-\frac{tcont}{\tau}\right)\right)$$

$$\cdots \ (13)$$

N in Equations (12) and (13) represents the number of cells that constitute the battery system.

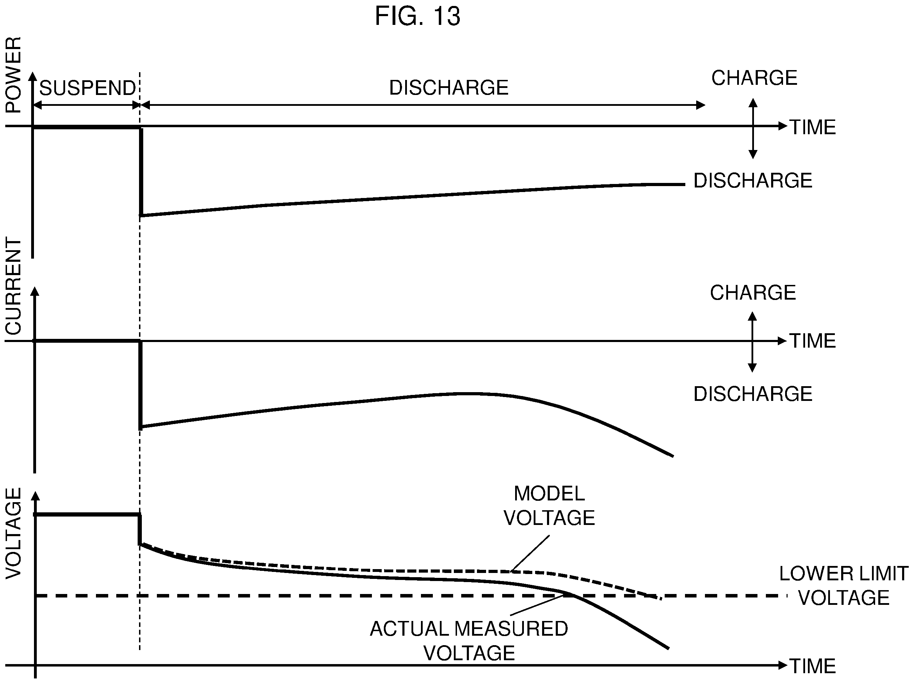

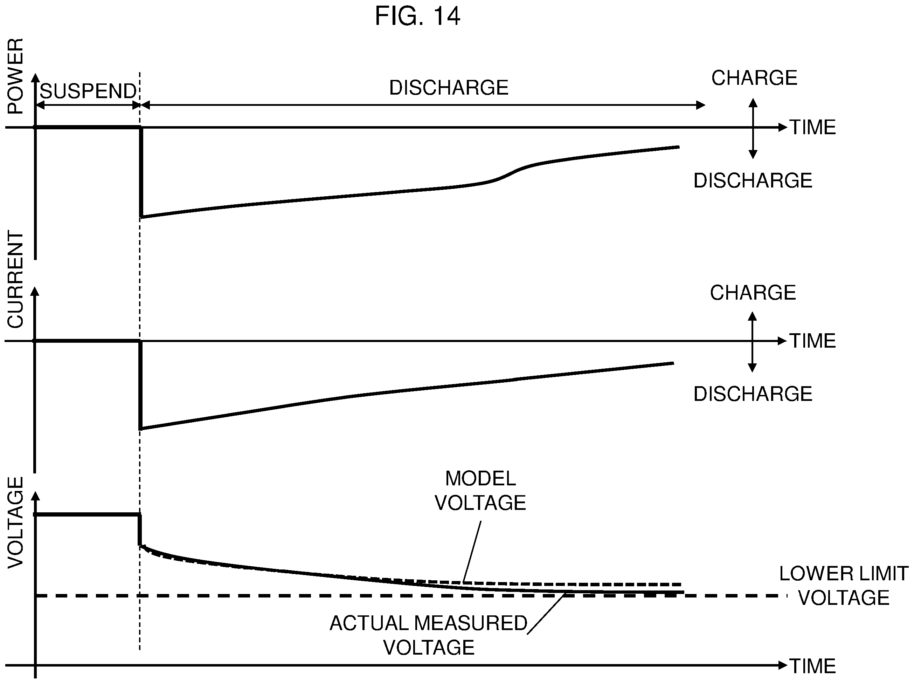

The advantageous effects of the present invention will be explained with reference to Figures 13 and 14. Figures 13 and 14 show the waveforms of power, current, and voltage obtained when the battery is discharged along with the available output power, which is updated in each calculation cycle; and Figures 13 and 14 show the waveforms before and after application of the present invention, respectively.

First, Figure 13 showing the state before the application of the present invention will be described. Discharge is started from the dormant state at a power equivalent to the available output power calculated by Equation (13). With discharge, the current flows, which lowers the SOC and thus gradually lowers the available discharge power. It can be seen that the voltage decreases over time as the current continuously flows, but at some point in the region where the diffusion resistance of lithium ions increases, which cannot be reproduced by the battery voltage equivalent circuit model used to calculate the available output power, an error occurs and the actual measured voltage is lower than the model voltage, which means that the internal resistance is higher. In this situation, the internal resistance to calculate the available output power should usually be larger, i.e., the available output power should be calculated smaller, but before application of the present invention, the difference between the actual measured voltage and the model voltage is not reflected in the available output power calculation, resulting in excessive power input and the actual measured voltage thus falls below the lower limit voltage.

On the contrary, in Figure 14, which shows similar test results when the present invention is applied, the correction factor k is calculated from the model voltage and actual measured voltage, which is reflected in the available output power, so that the power is corrected to a smaller value from the time the deviation between the model voltage and actual measured voltage occurred, thereby allowing the discharge to continue without deviation from the lower limit voltage.

According to this embodiment, reflecting the correction factor k based on the actual measured voltage and model voltage in the available input/output power calculation makes it possible to calculate the available input/output power that can prevent deviation from the upper and lower limit voltages due to modeling errors in the voltage equivalent circuit model of the secondary battery.

Although Figure 14 is used to explain the advantageous effect of Embodiment 1 referring to the case of a charge/discharge test in which power equivalent to the available output power is input as an example, the same effect can be expected when power equivalent to the available input power is input. In other words, a correction toward lower power is performed from the time the deviation between the model voltage and the actual measured voltage occurs, thereby allowing charging to be continued without deviation from the upper limit voltage.

In this embodiment, the correction factor is extracted as the ratio of the difference between OCV and model voltage and actual measured voltage as described in Equation (8) for the calculation method of the correction factor, which is not necessarily the case. It can be even simpler: a correction factor map with the difference between model voltage and OCV (model voltage difference) and the difference between actual measured voltage and OCV (actual measured voltage difference) as axes may be constructed in advance, and the model voltage difference and actual measured voltage difference during charging and discharging may be input to this map to output correction factors. Otherwise, the polarization voltage Vp (Vp_model) calculated based on the equivalent circuit model shown in Figure 8 and the actual measured value-based polarization voltage Vp (Vp_measure) calculated by subtracting OCV and Vo from the actual measured voltage may be directly extracted as resistance components that change with time, and the correction factor may be calculated as the ratio between these: any index that indicates the discrepancy of the internal resistance component may be adopted.

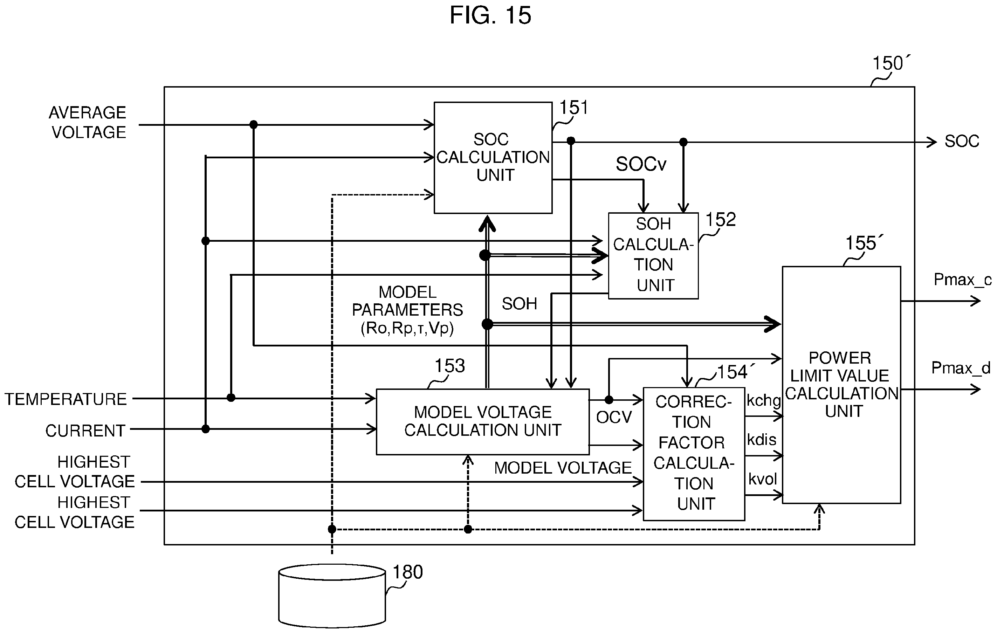

Embodiment 2 of the present invention will be described with reference to Figures 15 to 21.

Embodiment 1 shows an example where the correction factor k is calculated according to the difference between the actual measured voltage and the model voltage using Equation (8), and the calculated correction factor k is used to correct for the resistance component over time as shown in Equation (9) to calculate the available input and output power.

However, as shown in Figure 1, the battery system, the battery 100, is composed of an assembled battery 110 consisting of single batteries 111 connected in series, and the battery voltage can vary due to individual differences and temperature variations depending on each single battery 111. The available input and output power needs to be calculated as the maximum power within the range in which the voltages of all single batteries 111 constituting the assembled battery 110 do not deviate from the upper and lower limit voltages. Therefore, this embodiment describes an example case where the available input and output powers at which all of the single batteries 111 constituting the assembled battery 110 do not deviate from the upper and lower limit voltages are calculated by determining a correction factor that takes into account the voltage variation between the single batteries 111 and reflecting it in the available input and output power calculation.

The description of this embodiment focuses on the differences from Embodiment 1 and omits the description of the same configuration parts as in Embodiment 1.

The differences in this embodiment from Embodiment 1 are an assembled battery control unit 150', a correction factor calculation unit 154' and power limit value calculation unit 155' in the assembled battery control unit 150'.

First, the assembled battery control unit 150' will be described with reference to Figure 15. The difference from the assembled battery control unit 150 of Embodiment 1 is that the highest voltage (highest cell voltage) and the lowest voltage (lowest cell voltage) of the single batteries 111 constituting the assembled battery 110 are input to the correction factor calculation unit 154', and three correction factors: a correction factor kchg for the available input current, correction factor kdis for the available discharge current, and correction factor kvol for the voltage, which will be described later, are output and then input to the power limit value calculation unit 155'. The power limit value calculation unit 155' uses kchg, kdis, and kvol as inputs and outputs the maximum available input power Pmax_c and maximum available output power Pmax_d.

The correction factor calculation unit 154' will be described. The difference from the correction factor calculation unit 154 of Embodiment 1 is that the highest and lowest cell voltages are added to the input, the correction factor kchg for the available input current is calculated based on the highest cell voltage and model voltage, the correction factor kdis for the available discharge current is calculated based on the lowest cell voltage and model voltage, and the correction factor kvol for voltage is calculated based on the average voltage and model voltage.

Since the maximum available input current Imax_c needs to be set as a current value such that all the single batteries 111 constituting the assembled battery 110 do not deviate from the upper limit voltage, a correction factor is calculated based on the highest cell voltage, which is the highest voltage among all the single batteries 111 constituting the assembled battery 110, and is utilized. Equation (14) shown below is used to calculate kchg.

[Formula 14]

$$\text{kchg} = \frac{CCVmax - OCV}{CCVCalc - OCV} \quad \cdots \quad (14)$$

Similarly, the maximum available output current Imax_d needs to be set as a current value at which all the single batteries 111 constituting the assembled battery 110 do not deviate from the lower limit voltage, a correction factor is calculated based on the lowest cell voltage, which is the lowest voltage among all the single batteries 111 constituting the assembled battery 110, and is utilized. Equation (15) shown below is used to calculate kdis.

[Formula 15]

$$kdis = \frac{CCVmin-OCV}{CCVCalc-OCV} \quad \cdots \quad (15)$$

The correction of the internal resistance component used to calculate the voltage obtained when the available input and discharge currents are supplied, which is calculated when the available input power and available discharge power are calculated, corresponds to the sum of the single batteries 111 that constitute the assembled battery 110; therefore, the correction factor is calculated based on the average voltage of the entire assembled battery 110 (= total voltage/number of cells) and is utilized. Equation (16) shown below expresses kvol.
[Formula 16]

$$kvol = \frac{CCVave-OCV}{CCVCalc-OCV} \quad \cdots \quad (16)$$

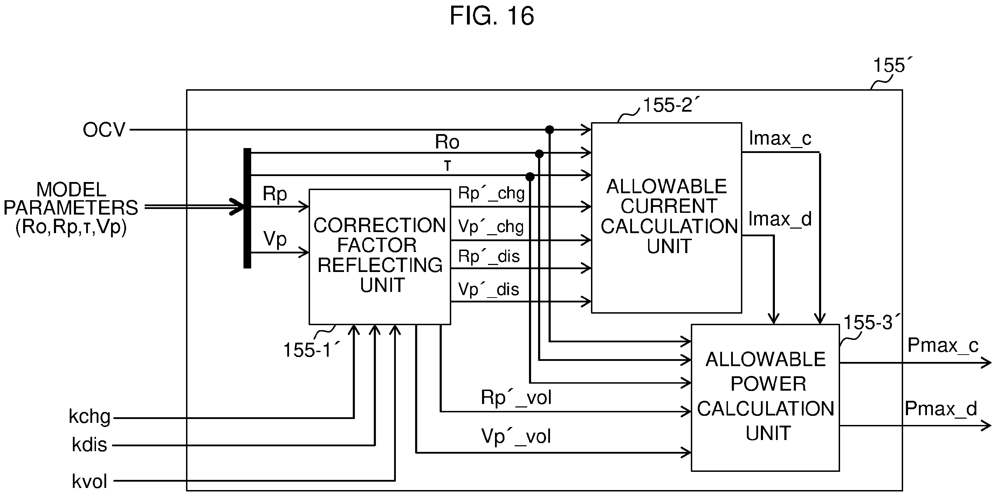

Next, the power limit value calculation unit 155' will be described with reference to Figure 16. The difference from the power limit value calculation unit 155' of Embodiment 1 is that the correction factors kchg, kdis, and kvol expressed by Equations (14) to (16) are used as inputs which are used to calculate the allowable currents (Imax_c and Imax_d) and allowable powers (Pmax_c and Pmax_d). Rp_chg and Vp_chg, and Rp_dis and Vp_dis, which are the results of correcting the internal resistance components utilized for calculating the allowable currents (Imax_c and Imax_d) based on the correction factors kchg and kdis, are calculated and output to an allowable current calculation unit 155-2', and at the same time, Rp_vol and Vp_vol, which are the results of correcting the internal resistance components utilized for the allowable powers (Pmax_c and Pmax_d) based on the correction factor kvol, are output to an allowable power calculation unit 155-3'; and the allowable current calculation unit 155-2' and allowable power calculation unit 155-3' perform the calculation process, which will be described below, based on the respective inputs.

A correction factor reflecting unit 155-1' will now be described. The correction factor reflecting unit 155-1' performs correction for the polarization resistance Rp and polarization voltage Vp, which are the same inputs as in Embodiment 1, using the correction factors kchg, kdis, and kvol. The internal resistance Rp'_chg and polarization voltage Vp'_chg for the available input current are calculated using kchg as expressed by the following equation (17).
[Formula 17]

$$\left. \begin{array}{l} Rp'\_chg = kchg \times Rp \\ Vp'\_chg = kchg \times Vp \end{array} \right\} \quad \cdots \quad (17)$$

Similarly, the internal resistance Rp'_dis and polarization voltage Vp'_dis for the available discharge current are calculated using kdis as expressed by the following equation (18).
[Formula 18]

$$\left. \begin{array}{l} Rp'\_dis = kdis \times Rp \\ Vp'\_dis = kdis \times Vp \end{array} \right\} \quad \cdots \quad (18)$$

Furthermore, the internal resistance Rp'_vol and polarization voltage Vp'_vol for voltage calculation are calculated using kvol as expressed by the following equation (19).
[Formula 19]

$$\left. \begin{array}{l} Rp'\_vol = kvol \times Rp \\ Vp'\_vol = kvol \times Vp \end{array} \right\} \quad \cdots \quad (19)$$

The allowable current calculation unit 155-2' calculates the maximum available input current Imax_c and maximum available output current Imax_d of the battery by the following equations (20) and (21), using the model parameters including Rp and Vp that are corrected by Equations (17) and (18), and OCV as inputs.
[Formula 20]

$$I_{chg} = \frac{Vmax - (OCV(SOC,T) + Vp'\_chg \times \exp\left(-\frac{tcont}{\tau}\right))}{Ro + Rp'\_chg \times (1 - \exp\left(-\frac{tcont}{\tau}\right))} \left.\vphantom{\int}\right\} \quad \cdots \quad (20)$$

$$I_{\max\_c} = \min(I_{chg}, Ilimit)$$

[Formula 21]

$$I_{dis} = \frac{\left(OCV(SOC,T) + Vp'\_dis \times \exp\left(-\frac{tcont}{\tau}\right)\right) - Vmin}{Ro + Rp'\_dis \times (1 - \exp\left(-\frac{tcont}{\tau}\right))} \left.\vphantom{\int}\right\} \quad \cdots \quad (21)$$

$$I_{\max\_d} = \min(I_{dis}, Ilimit)$$

Here, as in Embodiment 1, tcont and Ilimit in Equations (20) and (21) represent the upper current limit determined taking into account the assumed continuous energization time and the resistance of relays, fuses, and other components of the battery system.

Next, the allowable power calculation unit 155-3' calculates the maximum available input power Pmax_c and maximum available output power Pmax_d by the following equations (22) and (23), using as inputs the model parameters including Rp and Vp that are corrected by Equation (19), OCV, and Imax_c and Imax_d that are calculated by the allowable current calculation unit 155-2'.

[Formula 22]

$$P_{\max\_c} = N \times I_{\max\_c}$$
$$\times \left(OCV + I_{\max\atop c} \times (R_0 + Rp'\_vol \times (1 - \exp\left(-\frac{tcont}{\tau}\right))) \right.$$
$$\left. + Vp'\_vol \times \exp\left(-\frac{tcont}{\tau}\right)\right)$$
$$\cdots \quad (22)$$

[Formula 23]

$$P_{\max\_d} = N \times I_{\max\_d}$$
$$\times \left(OCV - I_{\max\atop d} \times (R_0 + Rp'\_vol \times (1 - \exp\left(-\frac{tcont}{\tau}\right))) \right.$$
$$\left. + Vp'\_vol \times \exp\left(-\frac{tcont}{\tau}\right)\right)$$
$$\cdots \quad (23)$$

N in Equations (22) and (23) represents the number of cells that constitute the battery system, as in Embodiment 1.

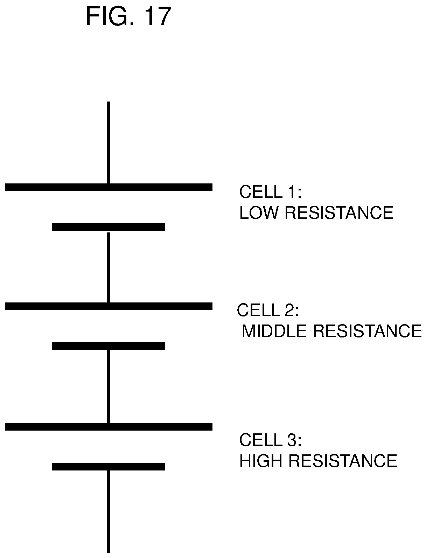

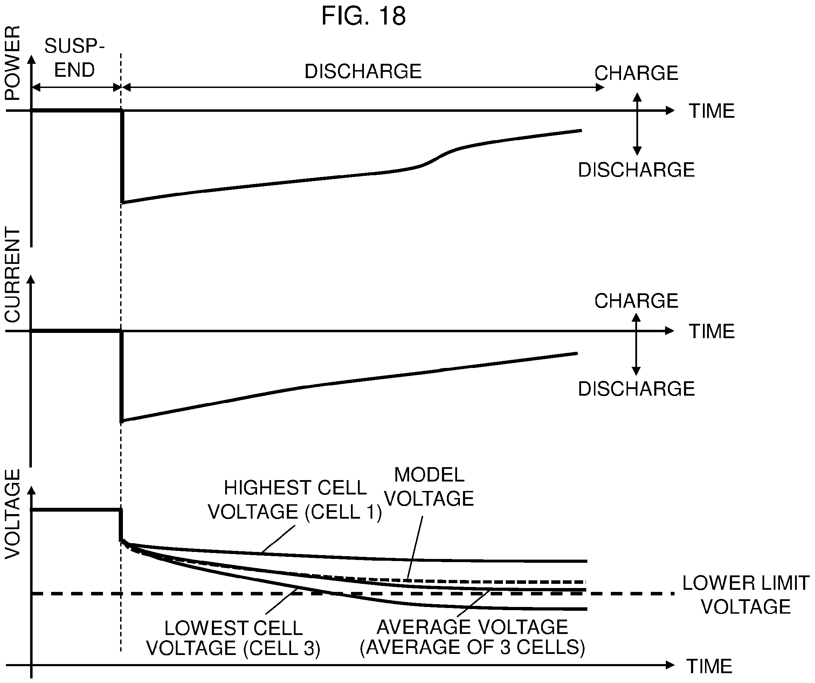

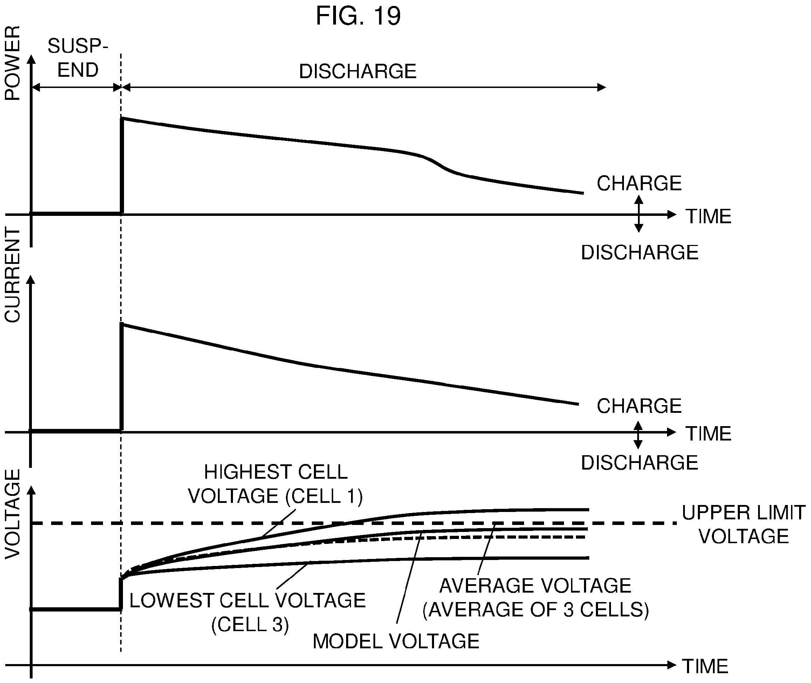

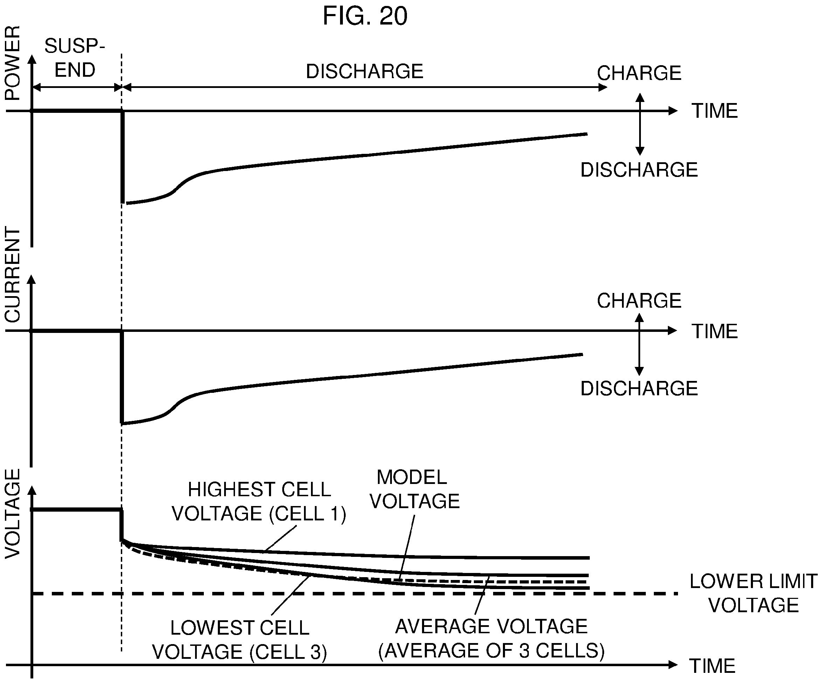

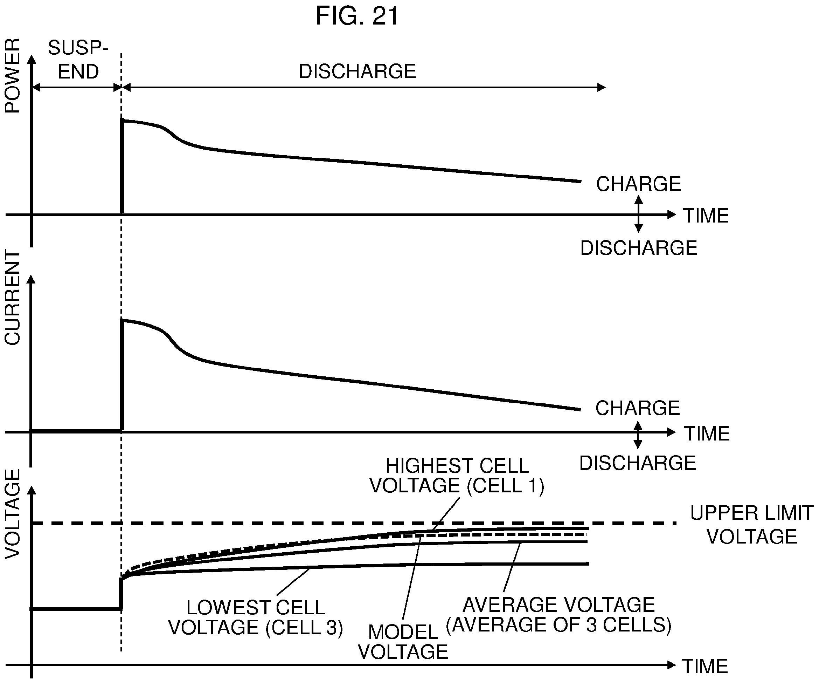

The advantageous effects of the present invention will be explained with reference to Figures 17 to 21. Figure 17 is a schematic view of an assembled battery consisting of three single batteries 111 connected in series with different internal resistance values. As in Figures 13 and 14 of Embodiment 1, Figures 18 to 21 show, for the assembled battery shown in Figure 17, the waveforms of power, current, and voltage obtained when the assembled battery is discharged or charged in accordance with the available output power or available input power, which is updated in each calculation cycle. Figures 18 and 19 are graphs based on the contents described in Embodiment 1, obtained when the correction factor is determined according to the average voltage, and Figures 20 and 21 each show the waveforms obtained after the application of this embodiment of the present invention.

Figure 18 will be described first. As in Embodiment 1, discharge is started from a dormant state at a power equivalent to the available output power. With discharge, the current flows and the SOC thus drops, so the available discharge power gradually decreases. The voltage decreases over time as the current continuously flows, but at some point in the region where the lithium ion diffusion resistance increases, which cannot be reproduced by the battery voltage equivalent circuit model used to calculate the available output power, the available output power is corrected at a correction factor corresponding to the difference between the average voltage of the three single batteries and the model voltage. Consequently, for the average voltage, discharging is continued in the lower limit voltage, but the lowest cell voltage deviates from the lower limit voltage due to a large voltage drop caused by the higher internal resistance than the average internal resistance of the three single batteries. Similarly, Figure 19 shows an example case where charging is performed according to the available input power, and it can be seen that while the average voltage does not deviate from the upper limit voltage, the highest cell voltage, which has high internal resistance, deviates from the upper limit voltage.

On the contrary, referring to Figure 20 showing the discharging test results with the available output power obtained when this embodiment is adopted, the correction factor kdis calculated from the model voltage and the lowest cell voltage is calculated and reflected in the available output power; thus, the power is corrected to a smaller value from the time the deviation between the model voltage and the lowest cell voltage occurs, allowing discharging to continue while the voltages of all the batteries, including the lowest cell voltage, do not deviate from the lower limit voltage.

Furthermore, referring to Figure 21 showing the charging test results with the available input power obtained when this embodiment is adopted, the correction factor kchg calculated from the model voltage and the highest cell voltage is calculated and reflected in the available input power; thus, the power is corrected to a smaller value from the time the deviation between the model voltage and the highest cell voltage occurs, allowing charging to continue while the voltages of all the batteries, including the highest cell voltage, do not deviate from the higher limit voltage.

According to this embodiment, the correction factor kdis based on the lowest cell voltage and model voltage and the correction factor kvol based on the average voltage and model voltage, which serve as correction factors for the available output power, are reflected in available output power calculation, and the correction factor kchg based on the highest cell voltage and model voltage and the correction factor kvol based on the average voltage and model voltage, which serve as correction factors for the available input power, are reflected in available input power calculation. It is thus possible to calculate the available input/output power that can prevent the voltages of all the batteries that are connected in series and constitute the secondary battery system from deviating from the upper and lower limit voltages.

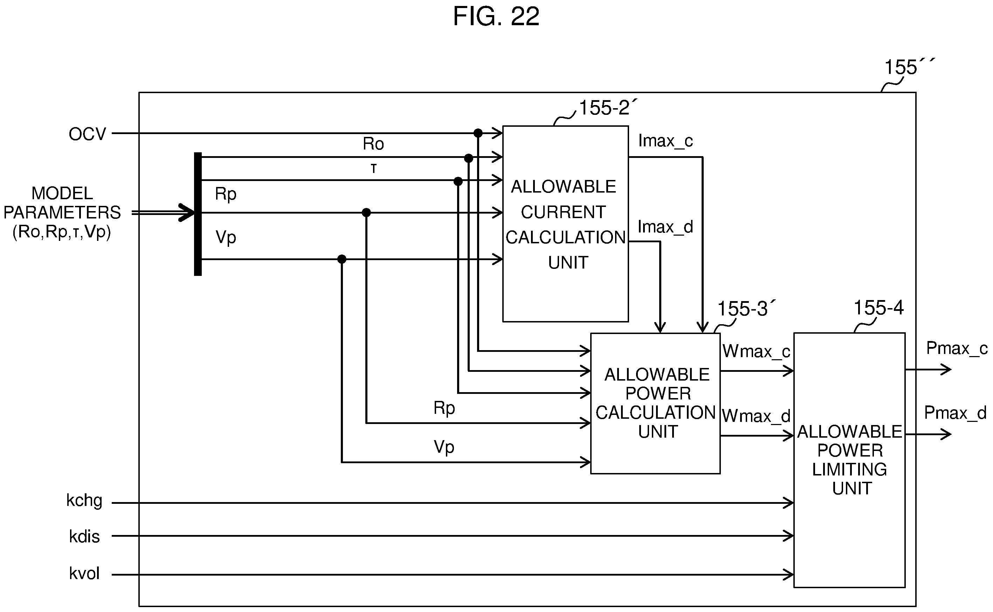

Embodiment 3 of the present invention will now be described with reference to Figures 22 to 25.

Embodiments 1 and 2 are explained a method of correcting the internal resistance component used for available input/output power calculation by calculating a correction factor according to the difference between the actual measured voltage, including the highest and lowest cell voltages, and the model voltage, and using the calculated correction factor k. This embodiment will explain a method of, more simply without correcting the internal resistance component, directly limiting the available input/output power to a smaller value when the correction factor exceeds a predetermined value.

The description of this embodiment focuses on the differences from Embodiments 1 and 2, and omits explanations of the same configuration parts as in Embodiments 1 and 2.

Figure 22 shows the functional configuration of a power limit value calculation unit 155" of this embodiment. The difference from the power limit value calculation unit 155' (shown in Figure 16) of Embodiment 2 is that, instead of inputting kchg, kdis, and kvol to the correction factor reflecting unit 155-1' like in the power limit value calculation unit 155' of Embodiment 2, this embodiment eliminates the correction factor reflecting unit 155-1' and kchg, kdis, and kvol are input to an allowable power limiting unit 155-4 which is disposed in a stage following the allowable power calculation unit 155-3'.

The allowable power limiting unit 155-4 estimates the available input/output power limiting rate corresponding to the inputs: kchg, kdis, and kvol, reflects the estimated results in the outputs of the allowable power calculation unit 155-3': Wmax_c and Wmax_d, and outputs the final available input/output power (Pmax_c and Pmax_d).

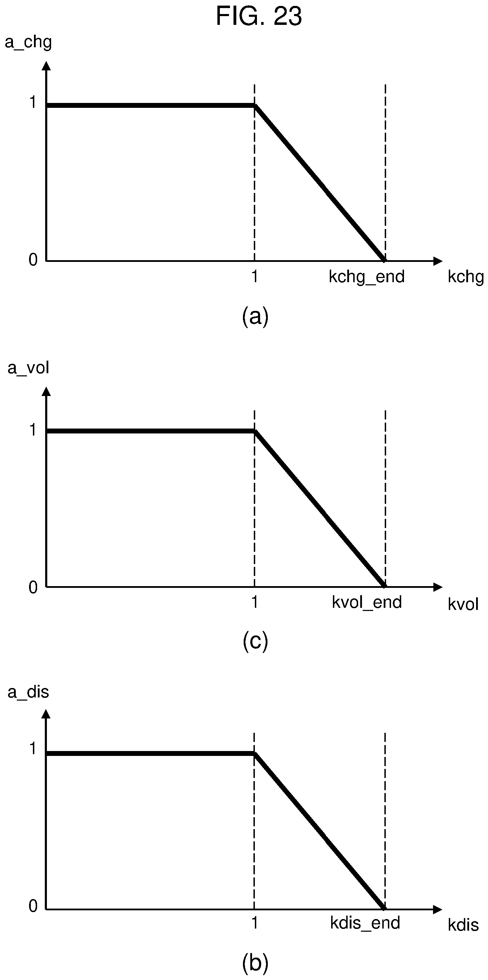

The calculation method of the limiting rate will now be explained with reference to Figure 23. Figure 23 shows graphs in which the horizontal axes represent the inputs: kchg, kdis, and kvol and the vertical axes represent the limiting factors: a_chg, a_dis, and a_vol corresponding to the input values. Settings are made for the start of limiting so that, when the input (correction factor) is 1, the limiting factor becomes zero at the thresholds (kchg_end, kdis_end, and kvol_end) for which the respective correction factors are individually set. Referring to an example shown in Figure 23, it is linear between 1 and each threshold (kchg_end, kdis_end, and kvol_end) where the limiting factor is 0; however, this is not necessarily the case, and it may be implemented as a map and any value corresponding to the input value may be set.

As described in Embodiment 2, there are correction factors (kchg and kdis) for input and available discharge current calculation and a correction factor (kvol) for input and voltage obtained during available discharge current energization; for this reason, in this embodiment, of a_chg corresponding to kchg and adis corresponding to kvol, the smaller one is utilized as the final available input power limiting factor (ain), and of a_dis and kvol corresponding to kdis, the smaller one is utilized as the available discharge power limiting factor (aout).

[Formula 24]

$$a_{\mathrm{out}} = \min\left(a_{dis}, a_{vol}\right) \cdots \ (24)$$

[Formula 25]

$$a_{\mathrm{out}} = \min\left(a_{dis}, a_{vol}\right) \quad \cdots \ (25)$$

Based on the limiting factor calculated by Equations (24) and (25), Pmax_c and Pmax_d are calculated using the following equations (26) and (27).

[Formula 26]

$$P_{\max\_c} = a_{in} \times N \times I_{\max\_c}$$
$$\times \left( OCV + I_{\max_c} \times (R_0 + Rp'\_vol \times (1 - \exp\left(-\frac{tcont}{\tau}\right))) \right.$$
$$\left. + Vp'\_vol \times \exp\left(-\frac{tcont}{\tau}\right) \right)$$

$$\ldots (26)$$

[Formula 27]

$$P_{\max\_d} = a_{out} \times N \times I_{\max\_d}$$
$$\times \left( OCV - I_{\max_d} \times (R_0 + Rp'\_vol \times (1 - \exp\left(-\frac{tcont}{\tau}\right))) \right.$$
$$\left. + Vp'\_vol \times \exp\left(-\frac{tcont}{\tau}\right) \right)$$

$$\ldots (27)$$

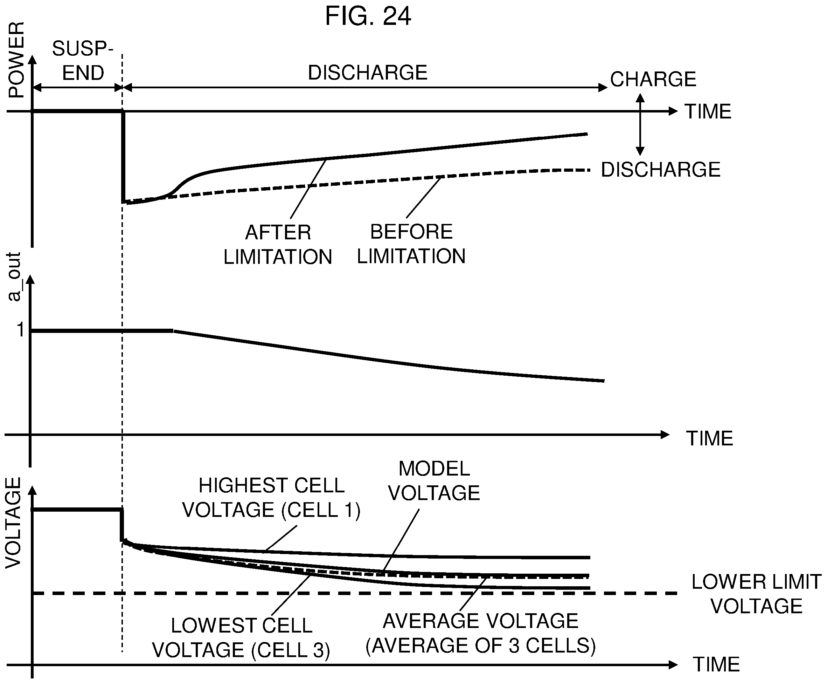

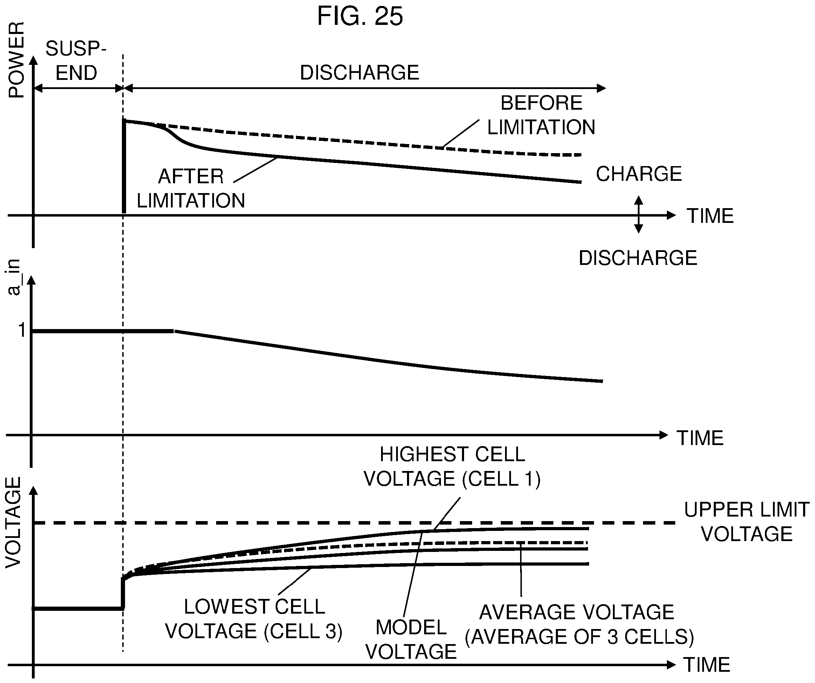

The advantageous effects of the present invention will be described with reference to Figures 24 and 25. As in Embodiment 2, Figure 24 shows the results of continuous input of power equivalent to the available output power to the battery, and Figure 25 shows the results of continuous input of power equivalent to the available input power to the battery. In the graphs in Figures 24 and 25, the horizontal axis represents, from the top row, time, and the vertical axes represent power, limiting factor, and voltage, respectively.

Looking at the limiting factor and voltage graphs in Figures 24 and 25, respectively, it can be seen that when the difference between the highest cell voltage and the model voltage shown in Figure 24 occurs, the limiting factor becomes less than 1; thus, the available output power is limited and the power applied to the batter decreases. Similarly, it can be seen that when the difference between the highest cell voltage and the model voltage shown in Figure 25 occurs, the limiting factor becomes less than 1; thus, the available input power is limited and the power applied to the battery decreases. Consequently, it was confirmed that in both examples shown in Figures 24 and 25, the available input/output power at which the voltages of all the batteries connected in series do not deviate from the upper and lower limit voltages has been successfully calculated.

According to this embodiment, the limiting factors (ain and aout) for limiting the available input/output power are calculated based on the correction factors kdis, kchg, and kvol that are described in Embodiment 2 and reflected in the available input/output power. It is thus possible to calculate the available input/output power that can prevent the voltages of all the batteries that are connected in series and constitute the secondary battery system from deviating from the upper and lower limit voltages.

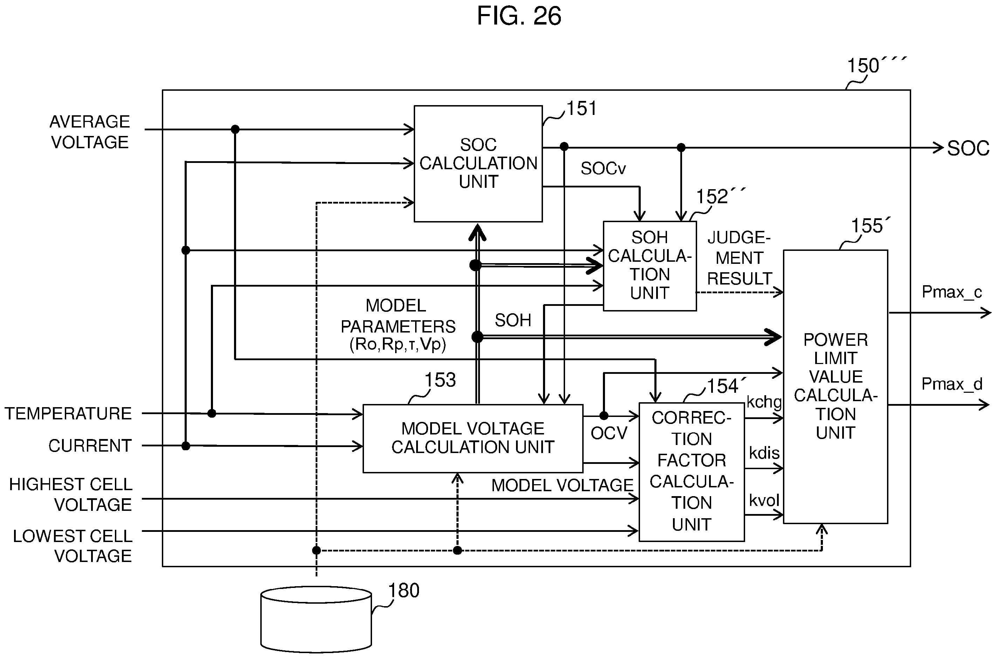

Embodiment 4 of the present invention will be described with reference to Figures 26 to 30.

Embodiments 1, 2, and 3 show examples in which a correction factor is calculated according to the difference between the actual measured voltage, including the highest and lowest cell voltages, and the model voltage, and the calculated correction factor k is used to calculate the available input and output powers. Embodiment 4 will describe the timing for reflecting the calculated correction factor.

In general, the assembled battery control unit 150 has means for detecting changes in the internal resistance of the battery due to deterioration (which corresponds to the SOH calculation unit 152 in the present invention). For the means to detect the internal resistance of the battery, the conditions for performing the calculation are set for the purpose of increasing the accuracy of the calculation. For example, in calculations utilizing the equivalent circuit model shown in Figure 8 as in this embodiment, calculations are performed under conditions where the equivalent circuit model can accurately calculate voltage behavior, for example, when the energization time is short. In the region where the calculation is judged to be feasible, the internal resistance can be estimated with high accuracy, and the model voltage and the actual measured voltage match, which means if the internal resistance calculation results can be directly reflected in the available input/output power calculation, it is not necessary to perform the correction processing as is explained in Embodiments 1 and 2 of the present invention. If the detection of internal resistance and the correction processing described in Embodiments 1 and 2 of the present invention are executed simultaneously, the internal resistance component utilized in the available input/output power calculation may fluctuate, and the available input/output power calculation results may show unexpected behavior such as oscillation.

For this reason, this embodiment will explain a method in which the correction factors described in Embodiments 1 and 2 are reflected only when the internal resistance calculation is out of the feasible range, and when the calculation is within the feasible range, the correction factors are not reflected to the internal resistance component to be utilized for available input/output power calculation.

The description of this embodiment focuses on the differences from Embodiments 1, 2, and 3, and omits explanations of the same configuration parts as in Embodiments 1, 2, and 3.

Figure 26 shows an assembled battery control unit 150"' of this embodiment. The difference from the assembled battery control unit 150' of Embodiment 2 (Figure 15) is that the judgement result given by a SOH calculation unit 152" is output to the power limit value calculation unit 155'.

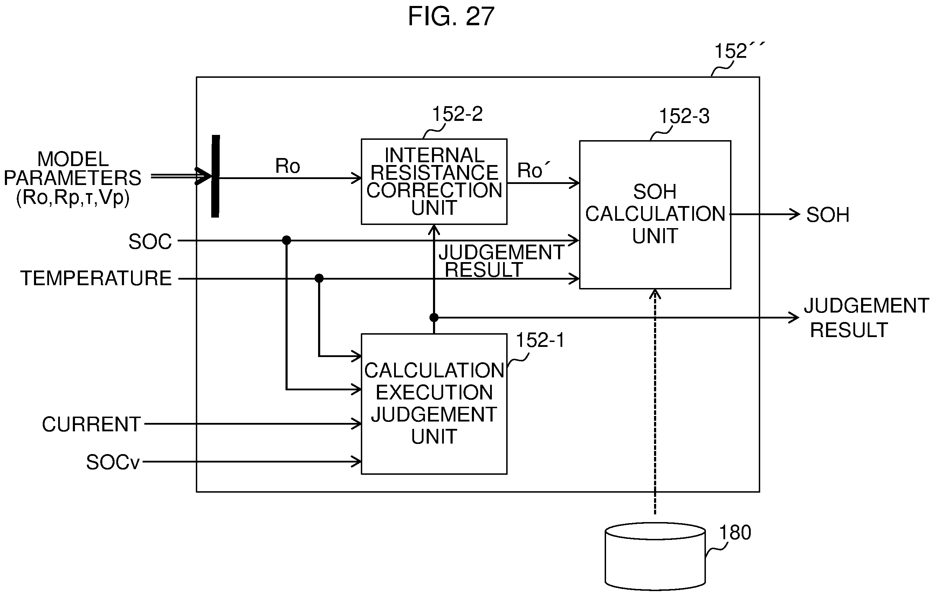

The SOH calculation unit 152" of this embodiment will be described with reference to Figure 27. The only difference from Embodiments 1 to 3 is that the judgement result output by the calculation execution judgement unit 152-1 is output to the outside of the SOH calculation unit 152". The judgement result is the result of judgement of whether or not the internal resistance can be corrected and the SOH can be calculated.

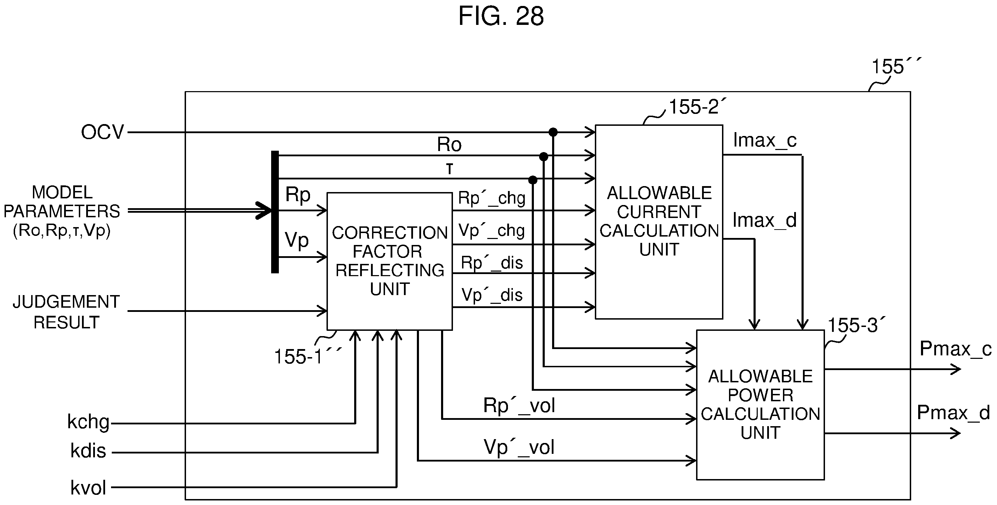

Next, the power limit value calculation unit 155" of this embodiment will be described with reference to Figure 28. The difference from Embodiments 1 to 3 is that the judgement result, which is a new input to the power limit value calculation unit 155", is added to the input of a correction factor reflecting unit 155-1". In the correction factor reflecting unit 155-1", the parameters (Rp'_chg, Vp'_chg, Rp'_dis, Vp'_dis, Rp'_vol, and Vp'_vol) that serve as outputs are calculated according to the judgement result, as expressed by the following equations (28) and (29).

Case 1) When the judgement result is OK (SOH calculation can be executed)

[Formula 28]

$$
\left.\begin{array}{l}
Rp\acute{}\_chg = Rp \\
Vp\acute{}\_chg = Vp \\
Rp\acute{}\_dis = Rp \\
Vp\acute{}\_dis = Vp \\
Rp\acute{}\_vol = Rp \\
Vp\acute{}\_vol = Vp
\end{array}\right\} \quad \cdots \quad (28)
$$

In Case 1), the SOH calculation is performed and Rp and Vp are determined based on the latest SOH, so the correction based on the correction factor is judged as being unnecessary and no correction is performed.

Case 2) When the judgement result is NG (SOH calculation cannot be executed)

[Formula 29]

$$
\left.\begin{array}{l}
Rp\acute{}\_chg = kchg \times Rp \\
Vp\acute{}\_chg = kchg \times Vp \\
Rp\acute{}\_dis = kdis \times Rp \\
Vp\acute{}\_dis = kdis \times Vp \\
Rp\acute{}\_vol = kvol \times Rp \\
Vp\acute{}\_vol = kvol \times Vp
\end{array}\right\} \quad \cdots \quad (29)
$$

Case 2) results in a region where the SOH calculation is not suitable for execution, i.e., where errors occur in the voltage equivalent circuit model itself. In this case, correction based on correction factors is performed.

Similarly in the case where the limiting factors ain and aout described in Embodiment 3 are utilized, in Case 1, "1" is set for ain and aout, and in Case 2, ain and aout calculated by the method described in Embodiment 3 are applied.

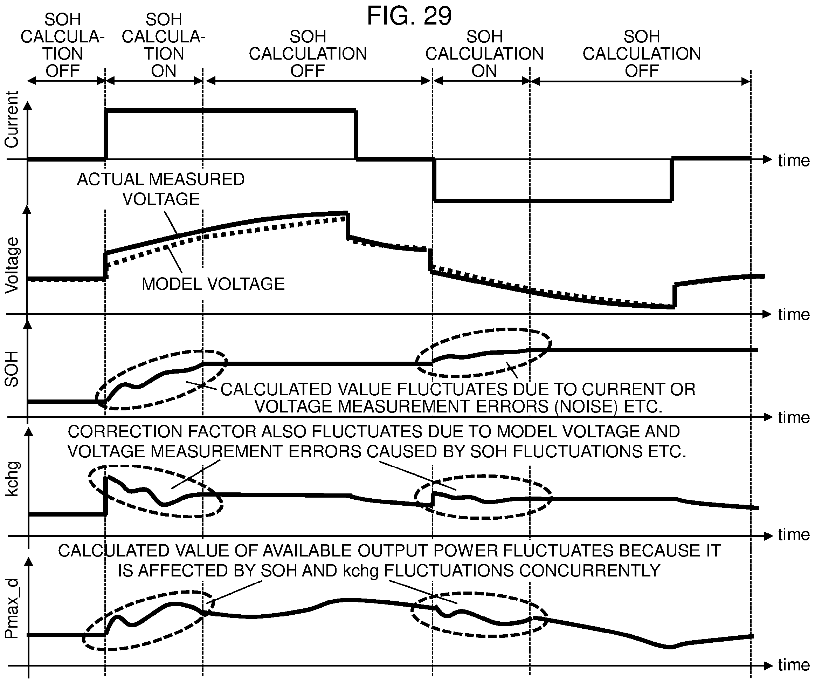

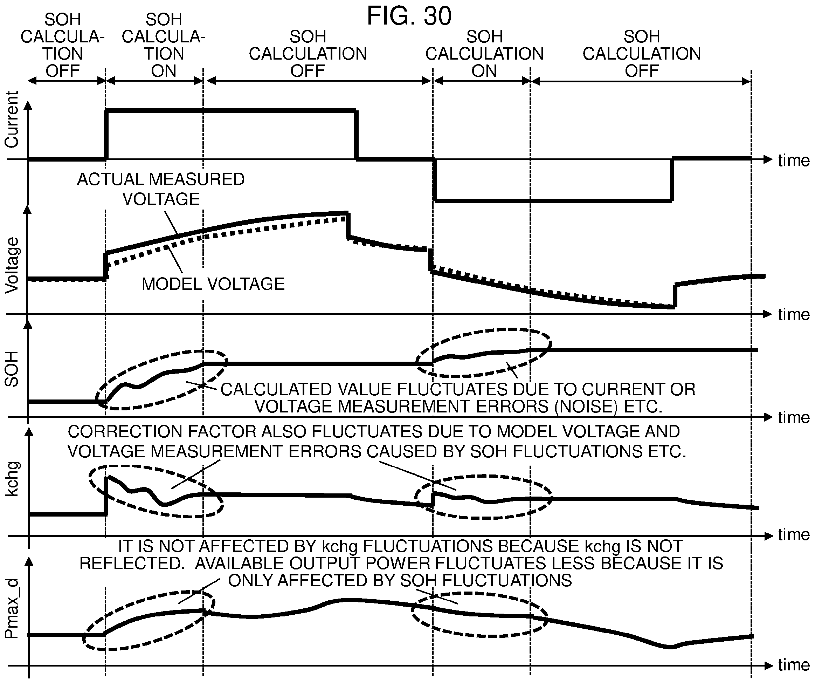

The advantageous effects of this embodiment will be described with reference to Figures 29 and 30. Figures 29 and 30 each show, from the top row, the waveforms of current, voltage, SOH, correction factor kchg, and maximum available output power Pmax_d versus time. Figure 29 shows the waveforms before the application of this embodiment, and Figure 30 shows the waveforms after the application of this embodiment.

Figures 29 and 30 both assume the case where SOH is updated when the current value is input and energization is established for a predetermined number of seconds, and while the SOH calculation is being updated, the model voltage is also updated at the same time as it is updated. Since the SOH calculation may fluctuate due to errors (noise) in current or voltage measurement, in the SOH calculation ON sections in the drawing, the SOH behaves as if it is being updated while oscillating. Accordingly, the difference between the model voltage updated in the model voltage calculation unit 153, which uses SOH as an input, and the actual measured voltage will also oscillate, which makes the correction factor kchg also oscillate.

Before application of this embodiment, the two oscillating components, SOH and kchg, are reflected in Pmax_c, so the value of Pmax_c will fluctuate due to the oscillation of both calculated values as shown in Figure 29; however, the application of this embodiment halts the reflection of kchg while the SOH calculation is being performed and thus eliminates the impact of kchg fluctuations. Consequently, for the behavior of Pmax_d, the calculated Pmax_d is more stable than the waveform obtained before the application of this embodiment.

The available output power is described with reference to Figures 29 and 30, and the available input power is expected to yield the same effect.

According to this embodiment, while the SOH operation is performed, only the resistance estimates in the equivalent circuit model of the battery are utilized, and the correction factors that are described in Embodiments 1 to 3 are not utilized but only when the SOH calculation is not performed, available input/output power correction using correction factors is employed, thereby suppressing the fluctuation of the available input/output power, and the available input/output power that can avoid deviation from the upper and lower limit voltages under conditions where the SOH calculation is not performed and where resistance estimation with the equivalent circuit model is difficult (e.g., when energized for a long period of time) can be calculated.

Since available input/output power is a factor that affects vehicle running control, and fluctuations in available input/output power have a negative impact on the user's operability (drivability) of the vehicle, suppressing fluctuations in available input/output power by applying this embodiment is expected to improve the user's operability of the vehicle.

This embodiment shows an example where the result of judging whether or not the SOH calculation can be performed is applied to whether or not the correction factor needs to be reflected. Alternatively, even without using the output from the SOH calculation unit 152", means to independently determine the need for reflection may be provided in the power limit value calculation unit 155', in which, for example, the correction factor is reflected only under certain conditions, such as when the energization is established for a long period of time, when the current is high, or when the difference between the actual measured voltage and OCV is large.

As described above, the disclosed battery control device includes a correction factor calculation unit 154 that determines a correction factor based on the deviation between the state of a secondary battery determined from a measured value related to the secondary battery and the state of the secondary battery calculated using a model related to the secondary battery; and a power limit value calculation unit 155 that employs correction based on the correction factor to calculate a value related to the available input/output power of the secondary battery.

Therefore, even if the deviation from the prediction based on the model occurs due to long-time energization of a large current and the like, the available input/output power of the battery can be accurately determined, the battery voltage is prevented from deviating from the upper and lower limit voltages, the input/output performance of the battery is maximized, and the battery system has secured reliability and is used efficiently.

In addition, in the disclosed battery control device, the state of the secondary battery determined from the measured value related to the secondary battery is a voltage change in the internal resistance based on an actual measured voltage obtained by measuring the voltage of the secondary battery, the state of the secondary battery calculated using the model related to the secondary battery is a voltage change in the internal resistance based on a model voltage determined using a voltage equivalent circuit model of the secondary battery, and the correction factor calculation unit determines, as the correction factor, the ratio between the voltage change in internal resistance based on the actual measured voltage and the voltage change in internal resistance based on the model voltage.

The power limit value calculation unit included in the battery control device uses the correction factor to correct model parameters used to calculate the current and/or power that the secondary battery can input and output.

Thus, the correction factors based on actual measured voltages can be easily determined and model parameters can be corrected, thereby calculating the current and power that can be input and output.

In addition, the power limit value calculation unit corrects, among the model parameters, a time-dependent resistance component in the voltage equivalent circuit model of the secondary battery and polarization voltage in the voltage equivalent circuit model of the secondary battery, based on the correction factor.

**EP 4 503 255 A1**

Thus, selectively correcting factors affected by the long-time energization of large currents improves the calculation accuracy of the available input/output power.

A correction factor map showing the relationship between an actual measured voltage difference, which is the difference between the actual measured voltage and open circuit voltage of the secondary battery, a model voltage difference, which is the difference between the model voltage and open circuit voltage of the secondary battery, and the correction factor may be constructed in advance, and the correction factor calculation unit may refer to the correction factor map based on the model voltage difference and the actual measured voltage difference during charging and discharging, thereby specifying the correction factor.

The correction factor calculation unit may calculate the correction factor as a ratio between a polarization voltage calculated based on the voltage equivalent circuit model of the secondary battery and a polarization voltage calculated by subtracting the open circuit voltage and the voltage change due to time-independent resistance from the actual measured voltage.

Thus, the correction factor can be obtained using any method.

For the secondary battery comprising multiple secondary batteries that are connected in series forming an assembled battery, the correction factor calculation unit determines the correction factor used to calculate the current and/or power that can be input, using as the actual measured voltage the highest voltage among the voltages of the multiple secondary batteries.

For the secondary battery comprising multiple secondary batteries that are connected in series forming an assembled battery, the correction factor calculation unit determines the correction factor used to calculate the current and/or power that can be output, using as the actual measured voltage the lowest voltage among the voltages of the multiple secondary batteries.

Hence, the available input and output powers at which all of the single batteries constituting the assembled battery do not deviate from the upper and lower limit voltages can be calculated.

The power limit value calculation unit can also calculate a limiting factor to limit the available input/output current and/or power of the secondary battery based on the correction factor, thereby limiting the available input/output current and/or power of the secondary battery to a smaller value.

Thus, directly limiting the available input/output current and/or power of the secondary battery allows the available input/output current and/or power to be calculated at a low load.

The disclosed battery control device further includes a SOH calculation unit 152 as a degradation rate calculation unit that calculates the degradation rate of the internal resistance of the secondary battery based on the current flowing in the secondary battery, voltage, and temperature; the degradation rate calculation unit determines that calculation of the degradation rate can be performed when the conditions for accurately calculating the degradation rate are satisfied; and upon determination that calculation of the degradation rate can be performed by the degradation rate calculation unit, the power limit value calculation unit suppresses correction based on the correction factor.

The degradation rate calculation unit determines whether or not to execute the calculation of the degradation rate depending on a condition based on at least one of the group consisting of: the charge rate, temperature, current, and current energization time related to the secondary battery.

This avoids the situation where the calculation of the degradation rate affects the correction rate, and allows the appropriate correction rate to be determined stably.

The aforementioned description is merely illustrative, and the present invention should not be limited to the configurations of the above embodiments. The above embodiments can be used in any combination. Although various embodiments and modifications are described above, the present invention should not be limited to these contents. Other possible modes within the scope of the technical concept of the present invention are also included within the scope of the invention.

For example, although the above embodiments describe an example case in which a lithium-ion battery is used as a secondary battery, but the same charge-discharge control can be performed even when other secondary batteries are used. In addition, the present invention is not necessarily applied to electric vehicles but can also be applied to secondary batteries for any application.

[Reference Signs List]

100...Battery, 110...Assembled battery, 111...Single battery, 112...Single battery group, 120...Single battery management unit, 121...Single battery control unit (monitoring four single batteries 111), 122...Voltage detection circuit, 123...Control circuit, 124...Signal input/output circuit, 125...Temperature detection unit, 130...Current detection unit, 140...Voltage detection unit, 150...Assembled battery control unit, 151...SOC calculation unit, 151-1...SOCi calculation unit, 151-2...SOCv calculation unit, 151-3...Combination calculation unit, 152...SOH calculation unit, 152-1... Calculation execution judgement unit, 152-2...Internal resistance correction unit, 152-3...SOH calculation unit, 152-4...Energization time measuring unit, 153...Model voltage calculation unit, 154...Correction factor calculation unit, 155...Power limit value calculation unit, 155-1... Correction factor reflecting unit, 155-2... allowable current calculation unit, 155-3...Allowable power calculation unit, 155-4...Allowable power limiting unit, 180...Memory unit, 200...Vehicle control unit, 300, 310...Relay, 400... Inverter, 410...Motor, 420...Motor/inverter control unit

**Claims**

1. A battery control device comprising:

    a correction factor calculation unit that determines a correction factor based on a deviation between a state of a secondary battery determined from a measured value related to the secondary battery and a state of the secondary battery calculated using a model related to the secondary battery; and
    a power limit value calculation unit that employs correction based on the correction factor to calculate a value related to available input/output power of the secondary battery.

2. The battery control device according to claim 1, wherein

    the state of the secondary battery determined from the measured value related to the secondary battery is a voltage change in internal resistance based on an actual measured voltage obtained by measuring voltage of the secondary battery,
    the state of the secondary battery calculated using the model related to the secondary battery is a voltage change in internal resistance based on a model voltage determined using a voltage equivalent circuit model of the secondary battery, and
    the correction factor calculation unit determines, as the correction factor, a ratio between the voltage change in the internal resistance based on the actual measured voltage and the voltage change in the internal resistance based on the model voltage.

3. The battery control device according to claim 1, wherein the power limit value calculation unit uses the correction factor to correct model parameters used to calculate current and/or power that the secondary battery can input and output.

4. The battery control device according to claim 3, wherein the power limit value calculation unit corrects, among the model parameters, a time-dependent resistance component in a voltage equivalent circuit model of the secondary battery and a polarization voltage in the voltage equivalent circuit model of the secondary battery, based on the correction factor.

5. The battery control device according to claim 1, wherein

    a correction factor map showing a relationship between an actual measured voltage difference, which is a difference between actual measured voltage and open circuit voltage of the secondary battery, a model voltage difference, which is a difference between model voltage and the open circuit voltage of the secondary battery, and the correction factor is constructed in advance, and
    the correction factor calculation unit refers to the correction factor map based on the model voltage difference and the actual measured voltage difference during charging and discharging, thereby specifying the correction factor.

6. The battery control device according to claim 1, wherein the correction factor calculation unit calculates the correction factor as a ratio between a polarization voltage calculated based on a voltage equivalent circuit model of the secondary battery and a polarization voltage calculated by subtracting open circuit voltage and voltage change due to time-independent resistance from actual measured voltage.

7. The battery control device according to claim 2, wherein for the secondary battery comprising multiple secondary batteries that are connected in series forming an assembled battery, the correction factor calculation unit determines the correction factor used to calculate current and/or power that can be input, using as the actual measured voltage the highest voltage among voltages of the multiple secondary batteries.

8. The battery control device according to claim 2, wherein for the secondary battery comprising multiple secondary batteries that are connected in series forming an assembled battery, the correction factor calculation unit determines the correction factor used to calculate current and/or power that can be output, using as the actual measured voltage the lowest voltage among voltages of the multiple secondary batteries.

9.   The battery control device according to claim 1, wherein the power limit value calculation unit calculates a limiting factor to limit available input/output current and/or power of the secondary battery based on the correction factor, thereby limiting the available input/output current and/or power of the secondary battery to a smaller value.

10.   The battery control device according to claim 1, further comprising a degradation rate calculation unit that calculates a degradation rate of internal resistance of the secondary battery based on current flowing in the secondary battery, voltage, and temperature, wherein

the degradation rate calculation unit determines that calculation of the degradation rate can be performed when conditions for accurately calculating the degradation rate are satisfied; and
upon determination that calculation of the degradation rate can be performed by the degradation rate calculation unit, the power limit value calculation unit suppresses the correction based on the correction factor.

11.   The battery control device according to claim 10, wherein the degradation rate calculation unit determines whether or not to execute the calculation of the degradation rate depending on a condition based on at least one of the group consisting of: a charge rate, temperature, current, and current energization time related to the secondary battery.

12.   A battery control method comprising:

by a battery control device, a correction factor calculation step of determining a correction factor based on a deviation between a state of a secondary battery determined from a measured value related to the secondary battery and a state of the secondary battery calculated using a model related to the secondary battery; and
a power limit value calculation step of employing correction based on the correction factor to calculate a value related to available input/output power of the secondary battery.

# FIG. 1

# FIG. 2

## FIG. 3

VOLTAGE

SOC CALCULATION UNIT 151

SOC

SOCv

SOH CALCULATION UNIT 152

MODEL PARAMETERS (Ro,Rp,τ,Vp)

SOH

POWER LIMIT VALUE CALCULATION UNIT 155

Pmax_c

Pmax_d

TEMPERATURE

CURRENT

MODEL VOLTAGE CALCULATION UNIT 153

OCV

CORRECTION FACTOR CALCULATION UNIT 154

k

MODEL VOLTAGE

150

180

EP 4 503 255 A1

FIG. 4

| SOC | 0 | 10 | ... | 90 | 100 |
|-----|---|----|-----|----|-----|
| OCV | 3 | 3.1 | | 3.9 | 4 |

## FIG. 5

CURRENT →

MODEL PARAMETERS (Ro,Rp,τ,Vp) ⇒

VOLTAGE →

Ro

Vp

SOCI CALCULATION UNIT 151-1 → SOCi

SOCV CALCULATION UNIT 151-2 → SOCv

COMBINATION CALCULATION UNIT 151-3 → SOC

151

180

EP 4 503 255 A1

FIG. 6

EP 4 503 255 A1

## FIG. 7

MODEL PARAMETERS (Ro,Rp,τ,Vp) →

Ro → **INTERNAL RESISTANCE CORRECTION UNIT** (152-2) → Ro´ →

SOC →

TEMPERATURE →

JUDGEMENT RESULT →

**CALCULATION EXECUTION JUDGEMENT UNIT** (152-1)

CURRENT →

SOCv →

**SOH CALCULATION UNIT** (152-3) → SOH

152

180

FIG. 8

FIG. 9

# FIG. 10

CURRENT

SUSPEND  DISCHARGE  CHARGE

TIME

DISCHARGE

VOLTAGE

MODEL VOLTAGE

ERROR
OCCURRENCE

ACTUAL MEASURED
VOLTAGE

TIME

# FIG. 11

EP 4 503 255 A1

# FIG. 12

FIG. 13

# FIG. 14

POWER

SUSPEND | DISCHARGE | CHARGE

TIME

DISCHARGE

CURRENT

CHARGE

TIME

DISCHARGE

VOLTAGE

MODEL VOLTAGE

LOWER LIMIT VOLTAGE

ACTUAL MEASURED VOLTAGE

TIME

EP 4 503 255 A1

FIG. 15

FIG. 16

EP 4 503 255 A1

FIG. 17

CELL 1:
LOW RESISTANCE

CELL 2:
 MIDDLE RESISTANCE

CELL 3:
HIGH RESISTANCE

FIG. 18

POWER

SUSP-
END

DISCHARGE

CHARGE

TIME

DISCHARGE

CURRENT

CHARGE

TIME

DISCHARGE

VOLTAGE

HIGHEST CELL
VOLTAGE (CELL 1)

MODEL
VOLTAGE

LOWER LIMIT
VOLTAGE

LOWEST CELL
VOLTAGE (CELL 3)

AVERAGE VOLTAGE
(AVERAGE OF 3 CELLS)

TIME

EP 4 503 255 A1

FIG. 19

EP 4 503 255 A1

# FIG. 20

# FIG. 21

POWER

SUSP-END

DISCHARGE

CHARGE

TIME

DISCHARGE

CURRENT

CHARGE

TIME

DISCHARGE

VOLTAGE

HIGHEST CELL
VOLTAGE (CELL 1)

UPPER LIMIT
VOLTAGE

LOWEST CELL
VOLTAGE (CELL 3)

MODEL
VOLTAGE

AVERAGE VOLTAGE
(AVERAGE OF 3 CELLS)

TIME

EP 4 503 255 A1

# FIG. 22

EP 4 503 255 A1

# FIG. 23

(a)

(c)

(b)

# FIG. 24

POWER

SUSP-END | DISCHARGE | CHARGE

TIME

AFTER LIMITATION  BEFORE LIMITATION

DISCHARGE

a_out

1

TIME

VOLTAGE

HIGHEST CELL VOLTAGE (CELL 1)    MODEL VOLTAGE

LOWEST CELL VOLTAGE (CELL 3)    AVERAGE VOLTAGE (AVERAGE OF 3 CELLS)

LOWER LIMIT VOLTAGE

TIME

EP 4 503 255 A1

FIG. 25

# FIG. 26

EP 4 503 255 A1

## FIG. 27

MODEL PARAMETERS (Ro,Rp,τ,Vp) → Ro → **INTERNAL RESISTANCE CORRECTION UNIT** (152-2) → Ro´ → **SOH CALCULATION UNIT** (152-3) → SOH

SOC

TEMPERATURE

JUDGEMENT RESULT

CURRENT

SOCv

**CALCULATION EXECUTION JUDGEMENT UNIT** (152-1)

JUDGEMENT RESULT

152´´

180

EP 4 503 255 A1

FIG. 28

EP 4 503 255 A1

# FIG. 29

SOH CALCULATION OFF | SOH CALCULATION ON | SOH CALCULATION OFF | SOH CALCULATION ON | SOH CALCULATION OFF

Current

Voltage

ACTUAL MEASURED VOLTAGE

MODEL VOLTAGE

SOH

CALCULATED VALUE FLUCTUATES DUE TO CURRENT OR VOLTAGE MEASUREMENT ERRORS (NOISE) ETC.

kchg

CORRECTION FACTOR ALSO FLUCTUATES DUE TO MODEL VOLTAGE AND VOLTAGE MEASUREMENT ERRORS CAUSED BY SOH FLUCTUATIONS ETC.

Pmax_d

CALCULATED VALUE OF AVAILABLE OUTPUT POWER FLUCTUATES BECAUSE IT IS AFFECTED BY SOH AND kchg FLUCTUATIONS CONCURRENTLY

# FIG. 30

SOH CALCULATION OFF | SOH CALCULATION ON | SOH CALCULATION OFF | SOH CALCULATION ON | SOH CALCULATION OFF

Current

→ time

Voltage

ACTUAL MEASURED VOLTAGE

MODEL VOLTAGE

→ time

SOH

CALCULATED VALUE FLUCTUATES DUE TO CURRENT OR VOLTAGE MEASUREMENT ERRORS (NOISE) ETC.

→ time

kchg

CORRECTION FACTOR ALSO FLUCTUATES DUE TO MODEL VOLTAGE AND VOLTAGE MEASUREMENT ERRORS CAUSED BY SOH FLUCTUATIONS ETC.

→ time

Pmax_d

IT IS NOT AFFECTED BY kchg FLUCTUATIONS BECAUSE kchg IS NOT REFLECTED. AVAILABLE OUTPUT POWER FLUCTUATES LESS BECAUSE IT IS ONLY AFFECTED BY SOH FLUCTUATIONS

→ time

EP 4 503 255 A1

## INTERNATIONAL SEARCH REPORT

| International application No. |
|---|
| **PCT/JP2023/013391** |

### A. CLASSIFICATION OF SUBJECT MATTER

**H01M 10/44**(2006.01)i; **G01R 31/382**(2019.01)i; **G01R 31/385**(2019.01)i; **G01R 31/389**(2019.01)i; **H01M 10/48**(2006.01)i; **H02J 7/00**(2006.01)i

FI: H01M10/44 P; G01R31/382; G01R31/385; G01R31/389; H01M10/48 P; H02J7/00 B; H02J7/00 P

According to International Patent Classification (IPC) or to both national classification and IPC

### B. FIELDS SEARCHED

Minimum documentation searched (classification system followed by classification symbols)

H01M10/44; G01R31/382; G01R31/385; G01R31/389; H01M10/48; H02J7/00

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | JP 2017-162661 A (HITACHI AUTOMOTIVE SYSTEMS LTD) 14 September 2017 (2017-09-14) paragraphs [0004], [0019], [0022]-[0023], [0032], [0059]-[0071], [0082], [0090], [0093], fig. 3, 9-11 | 1, 3-4, 9, 12 |
| A | | 2, 5-8, 10-11 |
| A | JP 2017-107763 A (HITACHI AUTOMOTIVE SYSTEMS LTD) 15 June 2017 (2017-06-15) entire text, all drawings | 1-12 |
| A | JP 2017-017907 A (HITACHI AUTOMOTIVE SYSTEMS LTD) 19 January 2017 (2017-01-19) entire text, all drawings | 1-12 |

☐ Further documents are listed in the continuation of Box C.    ☑ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **06 June 2023** | **20 June 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

## INTERNATIONAL SEARCH REPORT
**Information on patent family members**

International application No.

**PCT/JP2023/013391**

| Patent document cited in search report | | | Publication date (day/month/year) | Patent family member(s) | | | Publication date (day/month/year) |
|---|---|---|---|---|---|---|---|
| JP | 2017-162661 | A | 14 September 2017 | US | 2019/0023132 | A1 | |
| | | | | paragraphs [0004], [0033], [0036]-[0037], [0046], [0073]-[0085], [0096], [0104], [0107], fig. 3, 9-11 | | | |
| | | | | EP | 3429021 | A1 | |
| | | | | CN | 108701872 | A | |
| JP | 2017-107763 | A | 15 June 2017 | US | 2018/0375176 | A1 | |
| | | | | entire text, all drawings | | | |
| | | | | EP | 3389132 | A1 | |
| | | | | CN | 108370073 | A | |
| JP | 2017-017907 | A | 19 January 2017 | US | 2018/0226824 | A1 | |
| | | | | entire text, all drawings | | | |
| | | | | EP | 3319197 | A1 | |
| | | | | CN | 107534309 | A | |

Form PCT/ISA/210 (patent family annex) (January 2015)

**EP 4 503 255 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2013137935 A